# EUROPEAN PATENT SPECIFICATION

(11) **EP 4 703 863 B1**
(45) Date of publication and mention of the grant of the patent: **07.10.2026**
(21) Application number: 25194848.5
(22) Date of filing: 08.08.2025
(51) Int. Cl.: G06F 3/06, G06F 1/3296

(54) **STORAGE SYSTEM INCLUDING STORAGE DEVICE AND HOST DEVICE**
SPEICHERSYSTEM MIT SPEICHERVORRICHTUNG UND HOST-VORRICHTUNG
SYSTÈME DE STOCKAGE COMPRENANT UN DISPOSITIF DE STOCKAGE ET UN DISPOSITIF HÔTE

(30) Priority: 27.08.2024 KR 20240115253
(43) Date of publication of application: 04.03.2026
(73) Proprietor: Samsung Electronics Co., Ltd., Suwon-si, Gyeonggi-do 16677 (KR)
(72) Inventor: PARK, Jungsik, Suwon-si, 16677 (KR); SEO, Sungho, Suwon-si, 16677 (KR); CHO, Yongwon, Suwon-si, 16677 (KR); CHOE, Gyuseok, Suwon-si, 16677 (KR)
(74) Representative: Marks & Clerk LLP

(56) References cited:
- US-A1- 2018 101 492
- US-A1- 2022 206 966

## Description

### BACKGROUND

Inventive concepts relate to a storage system, and more particularly, to a storage system in which the efficiency of power supplied to a device controller may be enhanced.

Semiconductor memories are widely used to store data in various electronic devices such as computers, wireless communication devices, and the like. Non-volatile memories, as one of different types of semiconductor memories, are devices that can store data even in an environment where power is not supplied to a device. Various mobile devices or electronic devices such as smartphones, desktop computers, laptop computers, tablet personal computers (PCs), wearable devices, and the like are widely used. These electronic devices may include storage devices for storing data. A storage device used in a mobile device, a portable device, electronics of an automobile, or an embedded system, or the like, may be referred to as a universal flash storage (UFS) device. US 2022/206966 A1 discloses a UFS storage device with power saving by adjusting the data rate of the UFS data transmission.

### SUMMARY

Inventive concepts include a storage system in which voltages, having voltage levels adaptively regulated based on a data transmission rate, may be supplied to a storage device so that enhanced power efficiency may be provided.

Some example embodiments of inventive concepts provide an operating method of a storage device, the operating method including, providing mapping information to a host when an initialization operation is performed, the mapping information including information about a plurality of data transmission rates and voltage levels of a first voltage, receiving the first voltage from the host through a first voltage pin, the first voltage having a first voltage level, receiving a first change request from the host, the first change request being a request to change a data transmission rate from a first data transmission rate to a second data transmission rate, and receiving the first voltage from the host through the first voltage pin, the first voltage having a second voltage level mapped to the second data transmission rate.

Some example embodiments of inventive concepts provide, there is provided a storage device including a non-volatile memory, an interconnect circuit connected to a host through an input/output pin, a first pin configured to receive a first voltage, and a device controller configured to control an operation of the non-volatile memory based on a command received through the input/output pin, to provide mapping information about data transmission rates and voltage levels to the host through the input/output pin, and to drive the interconnect circuit based on a first voltage having a voltage level mapped to a data transmission rate about the input/output pin.

Some example embodiments of inventive concepts provide a storage system including a storage device configured to drive an internal circuit based on a first voltage and output mapping information about a plurality of data transmission rates and voltage levels of the first voltage, and a host device configured to transmit/receive data to/from the storage device based on a first data transmission rate, obtain a first voltage level mapped to the first data transmission rate based on the mapping information, and provide the first voltage having the first voltage level to the storage device.

Some example embodiments of inventive concepts provide a host device including a host controller configured to control a storage device, a clock generator configured to generate a clock signal provided to the storage device, a power management integrated circuit configured to generate a plurality of voltages supplied to the storage device, and an interconnect circuit configured to receive mapping information about a plurality of data transmission rates and voltage levels of an input/output pin from the storage device through the input/output pin, wherein the host controller is configured to obtain a voltage level mapped to a data transmission rate of the input/output pin based on the mapping information, and control the power management integrated circuit for a voltage level of a first voltage among the plurality of voltages to have the obtained voltage level. A reference to an 'input/output pin', may be a reference to one or more pins or physical pins.

At least some of the above and other features of the invention are set out in the claims.

### BRIEF DESCRIPTION OF THE DRAWINGS

Some example embodiments will be more clearly understood from the following detailed description taken in conjunction with the accompanying drawings in which:
FIG. 1 is a block diagram illustrating a storage system according to some example embodiments;
FIG. 2 is a block diagram illustrating a storage system according to some example embodiments;
FIG. 3 is a block diagram illustrating the storage system according to some example embodiments;
FIG. 4 is a diagram illustrating an operating method of the storage system according to some example embodiments;
FIG. 5 is a diagram illustrating a mapping table DR2LMT about a data transmission rate and a level;
FIG. 6 is a diagram illustrating a mapping table L2VLMT about a level and a voltage level;
FIG. 7 is a diagram illustrating voltage levels of a VCC voltage, a VCCQ voltage, and a VCCQL voltage according to some example embodiments;
FIG. 8 is a diagram illustrating voltage levels of the VCC voltage, the VCCQ voltage, and the VCCQL voltage according to some example embodiments;
FIG. 9 is a diagram illustrating a data transmission rate changing operation between a host and a storage device according to some example embodiments;
FIG. 10 is a diagram illustrating a data transmission rate changing operation between the host and the storage device according to some example embodiments;
FIG. 11 is a diagram illustrating a data transmission rate changing operation between the host and the storage device according to some example embodiments;
FIG. 12 is a diagram illustrating a data transmission rate changing operation between the host and the storage device according to some example embodiments;
FIG. 13 illustrates an interface between a host and a storage device according to some example embodiments;
FIG. 14 is a flowchart illustrating an initialization operation and a data transmission rate changing operation between the host and the storage device according to some example embodiments;
FIG. 15 is a diagram illustrating an initialization operation and a data transmission rate changing operation according to some example embodiments;
FIG. 16 is a timing diagram illustrating a line-reset signal according to some example embodiments;
FIG. 17 is a diagram illustrating a universal flash storage (UFS) system according to some example embodiments; and
FIGS. 18A through 18C are diagrams illustrating a form factor of a UFS card.

### DETAILED DESCRIPTION

Hereinafter, some example embodiments of inventive concepts will be described in detail with reference to the accompanying drawings.

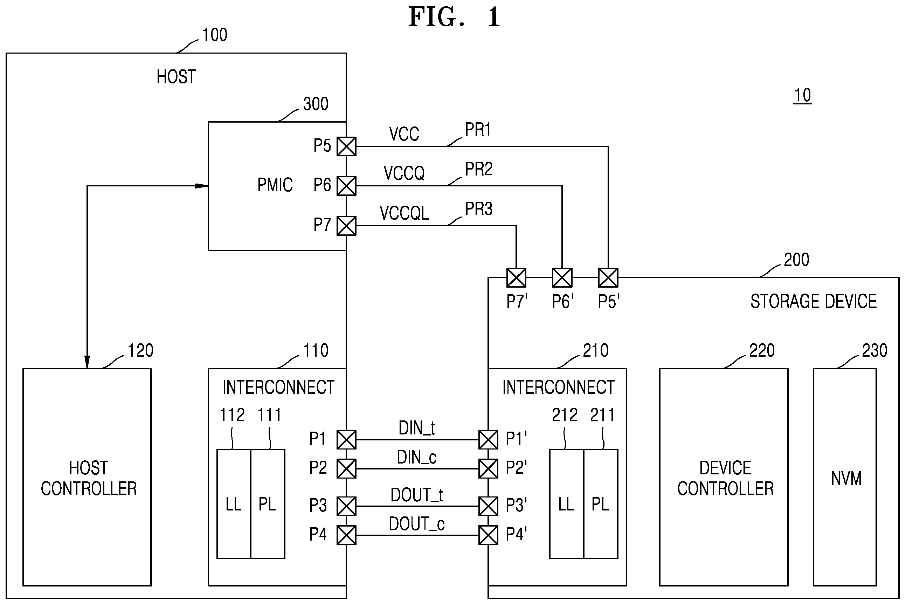

FIG. 1 is a block diagram illustrating a storage system 10 according to some example embodiments.

When the terms "approximately" or "about" are used in this specification in connection with a numerical value, it is intended that the associated numerical value includes a manufacturing or operational tolerance (e.g., ±10%) around the stated numerical value. Moreover, when the words "approximately" and "about" are used in connection with geometric shapes, it is intended that precision of the geometric shape is not required but that latitude for the shape is within the scope of the disclosure. Further, regardless of whether numerical values or shapes are modified as "approximately" or "about" it will be understood that these values and shapes should be construed as including a manufacturing or operational tolerance (e.g., ±10%) around the stated numerical values or shapes.

It will be understood that elements and/or properties thereof may be recited herein as being "the same" or "equal" as other elements, and it will be further understood that elements and/or properties thereof recited herein as being "identical" to, "the same" as, or "equal" to other elements may be "identical" to, "the same" as, or "equal" to the other elements and/or properties thereof. Elements and/or properties thereof that are "the same" or "equal" to other elements and/or properties thereof will be understood to include elements and/or properties thereof that are identical to, the same as, or equal to the other elements and/or properties thereof within manufacturing tolerances and/or material tolerances (e.g., ±10%). Elements and/or properties thereof that are identical, the same, and/or equal as other elements and/or properties thereof may be structurally the same or substantially the same, functionally the same or substantially the same, and/or compositionally the same or substantially the thereof.

Referring to FIG. 1, the storage system 10 may include a host 100 and a storage device 200. For example, the host 100 and the storage device 200 may be connected to each other according to a protocol defined in a universal flash storage (UFS) specification published by Joint Electron Device Engineering Council (JEDEC), an M-PHY specification published by MIPI Alliance, and a UniPro specification. In some example embodiments, the host 100 may be a UFS host, and the storage device 200 may be a UFS storage device. In some example embodiments, the host 100 may be referred to as a host device.

The storage system 10 may be implemented as an electronic device such as a personal computer (PC), a laptop computer, a mobile phone, a smartphone, a tablet PC, a personal digital assistant (PDA), an enterprise digital assistant (EDA), a digital still camera, a digital video camera, an audio device, a portable multimedia player (PMP), a personal navigation device or a portable navigation device (PND), an MP3 player, a handheld game console, or an e-book, but example embodiments are not limited thereto. Also, the storage system 10 may be implemented as various types of electronic devices such as wristwatches or wearable devices such as head-mounted displays (HMDs), but example embodiments are not limited thereto.

The host 100 may include an interconnect unit 110, a host controller 120, and a power management integrated circuit (PMIC) 300. The host 100 may control a data processing operation, for example, a data reading operation or a data writing operation on the storage device 200. The host 100 may be, or include, a data processing device capable of processing data, such as a central processing unit (CPU), a processor, a microprocessor or an application processor (AP), or the like, but example embodiments are not limited thereto. The host 100 may execute an operating system (OS) and/or various applications. In some example embodiments, the storage system 10 may be included in a mobile device, and the host 100 may be implemented as an AP. In some example embodiments, the host 100 may be implemented as a system-on-a-chip (SoC) and thus may be embedded in an electronic device. The host controller 120 may control the overall operation of the host 100. In some example embodiments, the host controller 120 may generate a PMIC command for controlling the PMIC 300. The PMIC 300 may change a voltage level of a VCCQL voltage based on the PMIC command. Although, in FIG. 1, the interconnect unit 110 and the host controller 120 may be configurations that may distinguish from each other (or different/separate from each other), the host controller 120 may be a concept (or a single concept) including the interconnect unit 110. The interconnect unit 110 may also be referred to as an interconnect circuit.

The storage device 200 includes an interconnect unit 210, a device controller 220, and a non-volatile memory 230. The device controller 220 may control the non-volatile memory 230 to write data into the non-volatile memory 230, in response to receiving a write request from the host 100. The device controller 220 may control the non-volatile memory 230 to read data stored in the non-volatile memory 230, in response to receiving a read request from the host 100. The non-volatile memory 230 may include a plurality of memory cells, and for example, the plurality of memory cells may be flash memory cells, but example embodiments are not limited thereto. In some example embodiments, the plurality of memory cells may be negative AND (NAND) flash memory cells, but example embodiments are not limited thereto. However, inventive concepts are not limited thereto, and some example embodiments, the plurality of memory cells may be resistive memory cells such as resistive random access memory (RAM)(ReRAM), phase change RAM (PRAM) or magnetic RAM (MRAM), but example embodiments are not limited thereto. Although, in FIG. 1, the interconnect unit 210 and the device controller 220 may be configurations that may distinguish from each other (or different/separate from each other), the device controller 220 may be a concept (or a single concept) including the interconnect unit 210. The interconnect unit 210 may also be referred to as an interconnect circuit.

The host 100 may include pins P1 and P2, and the storage device 200 may include pins P1' and P2' respectively connected to the pins P1 and P2. The storage device 200 may receive input signals, for example, differential input signals DIN_t and DIN_c from the host 100 through the pins P1' and P2'. Signal lines through which the differential input signals DIN_t and DIN_c may be transmitted, may constitute a receiving lane.

The host 100 may include pins P3 and P4, and the storage device 200 may include pins P3' and P4' connected to the pins P3 and P4, respectively. The storage device 200 may transmit output signals, for example, differential output signals DOUT_t and DOUT_c to the host 100 through the pins P3' and P4'. Signal lines through which the differential input signals DOUT_t and DOUT_c may be transmitted, may constitute a transmission lane.

The host 100 may further include pins P5, P6, and P7. The storage device 200 may include pins P5', P6', and P7' respectively connected to the pins P5, P6, and P7. The pin P5 and the pin P5' may be connected to each other through a first power rail PR1. The pin P6 and the pin P6' may be connected to each other through a second power rail PR2. The pin P7 and the pin P7' may be connected to each other through a third power rail PR3. However, example embodiments are not limited thereto, and the pin P5 and the pin P5' may be in direct contact with each other without going through the first power rail PR1, the pin P6 and the pin P6' may be in direct contact with each other without going through the second power rail PR2, and the pin P7 and the pin P7' may be in direct contact with each other without going through the third power rail PR3.

The PMIC 300 may provide a VCC voltage to the storage device 200 through the pin P5, may provide a VCCQ voltage to the storage device 200 through the pin P6, and may provide a VCCQL voltage to the storage device 200 through the pin P7. The VCC voltage may be a main power supply voltage for the storage device 200 and may have a value of about 2.4 V to about 3.6 V. The VCCQ voltage may be a power supply voltage for supplying a voltage in a low range, may be mainly for the device controller 220, and may have a value of about 1.14 V to about 1.26 V. The VCCQL voltage may be a power supply voltage for supplying a voltage in a range lower than the VCCQ voltage, may be mainly for the device controller 220, and may have a voltage level that may change according to a data transmission rate.

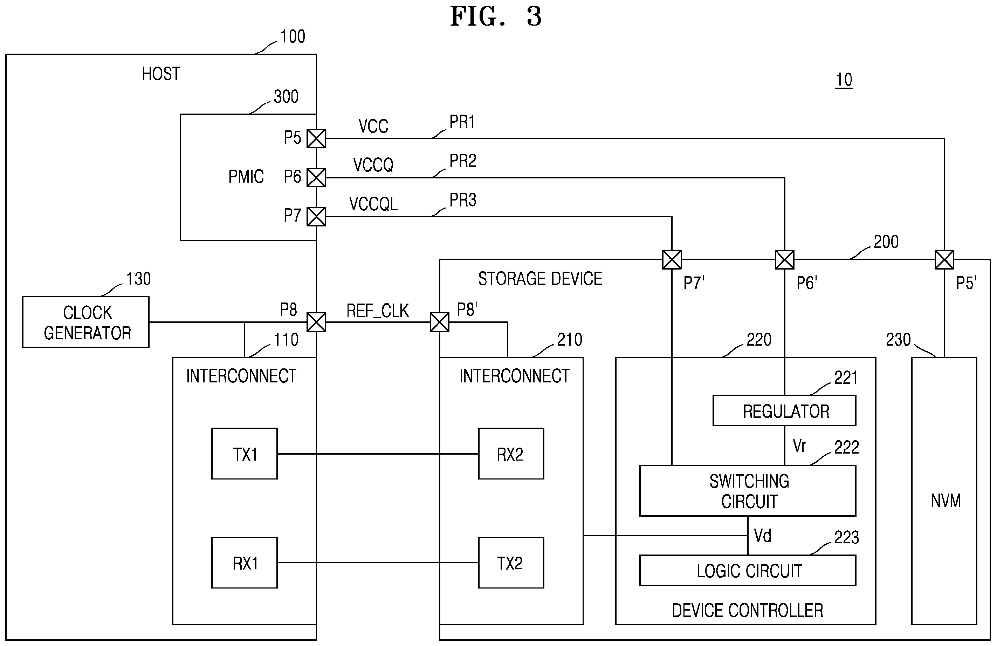

The device controller 220 may generate a driving voltage based on one of the VCCQ voltage and the VCCQL voltage received from the host 100. In the present specification, the driving voltage may mean a voltage required (or used, or beneficial) to perform an operation of various functional blocks inside the device controller 220. For example, the driving voltage may be a voltage required (or used, or beneficial) to drive a logic circuit (e.g., 223 of FIG. 3) of the device controller 220. Alternatively, or additionally, the driving voltage may mean a voltage required (or used, or beneficial) to drive an input/output circuit (e.g., the interconnect unit 210 of FIG. 3) of the storage device 200. The logic circuit and the input/output circuit may be referred to as internal circuits of the storage device 200. In some example embodiments, the driving voltage may be referred to as a logic voltage, an internal voltage, or an input/output voltage.

The device controller 220 may generate a driving voltage based on the VCCQ voltage during an initialization operation. In some example embodiments, when the device controller 220 generates the driving voltage based on the VCCQ voltage, the device controller 220 may generate a regulated voltage by regulating the voltage level of the VCCQ voltage using a voltage regulator, and may use the regulated voltage as the driving voltage. However, example embodiments are not limited thereto, and the device controller 220 may also generate a driving voltage based on the VCCQL voltage in at least some time periods of the initialization operation.

The device controller 220 may generate a driving voltage based on the VCCQL voltage during a normal operation. The device controller 220 may use the VCCQL voltage directly as a driving voltage without regulating the voltage level of the VCCQL voltage in at least some time periods of the initialization operation or during the normal operation. In the present specification, the normal operation may mean an operation of transmitting/receiving data between the host 100 and the storage device 200 after the initialization operation.

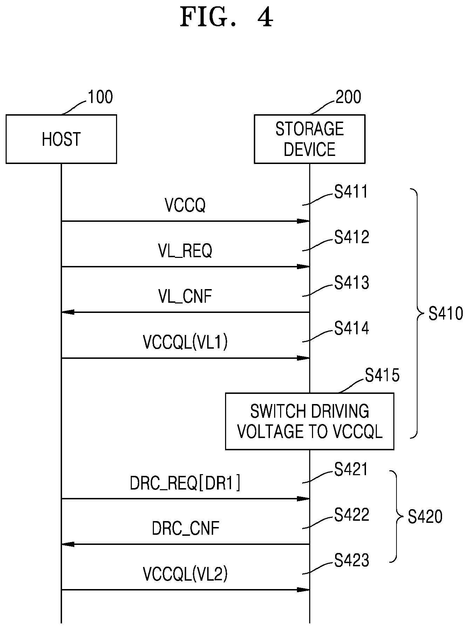

In some example embodiments, the host 100 may receive voltage level information from the storage device 200 during the initialization operation. The voltage level information may be information about voltage levels of the VCCQL voltage mapped to data transmission rates. For example, the host 100 may provide a voltage level information request (e.g., VL_REQ of FIG. 4) for requesting the voltage level information to the storage device 200. The storage device 200 may provide a voltage level information response (e.g., VL_CNF of FIG. 4) corresponding to the voltage level information request to the host 100. The voltage level information response may include the voltage level information, e.g., information about voltage levels of the VCCQL voltage mapped to data transmission rates.

The host 100 and the storage device 200 may perform a data transmission rate changing operation after the initialization operation. For example, the host 100 may provide a data transmission rate changing request (e.g., DRC_REQ of FIG. 4) to the storage device 200 during the data transmission rate changing operation. The storage device 200 may provide the data transmission rate changing response (e.g., DRC_CNF of FIG. 4) to the host 100. The host 100 and the storage device 200 may transmit/receive data to/from the storage device 200 according to the changed data transmission rate. The host 100 and the storage device 200 may adjust the data transmission rate by changing the frequency of an internal clock signal used in data transmission.

According to some example embodiments, the host 100 may change the voltage level of the VCCQL voltage based on the voltage level information during the data transmission rate changing operation. For example, the host 100 may change the voltage level of the VCCQL voltage to a voltage level mapped to the changed data transmission rate, based on the voltage level information. The storage device 200 may use the VCCQL voltage having the changed voltage level directly as a driving voltage.

According to some example embodiments, the device controller 220 may receive the VCCQL voltage adaptively changed according to the data transmission rate from the host 100 and may use the VCCQL voltage directly as a driving voltage rather than generating a driving voltage by regulating the VCCQL voltage. Thus, the storage system 10 may save power consumed during voltage conversion and thus, may provide enhanced (or improved) power efficiency.

The interconnect units 110 and 210 may provide an interface for exchanging data between the host 100 and the storage device 200. In some example embodiments, the interconnect unit 110 may include a physical layer (PL) 111 and a link layer (LL) 112, and the physical layer (PL) 111 may be connected to the pins P1, P2, P3, and P4. Similarly, the interconnect unit 210 may include a physical layer (PL) 211 and a link layer (LL) 212, and the physical layer (PL) 211 may be connected to the pins P1', P2', P3', and P4'. Each of the physical layers 111 and 211 may include physical configurations for exchanging data between the host 100 and the storage device 200, and for example, at least one transmitter and at least one receiver. Each of the link layers 112 and 212 may manage transmission and composition of data and may also manage integrity and error of data.

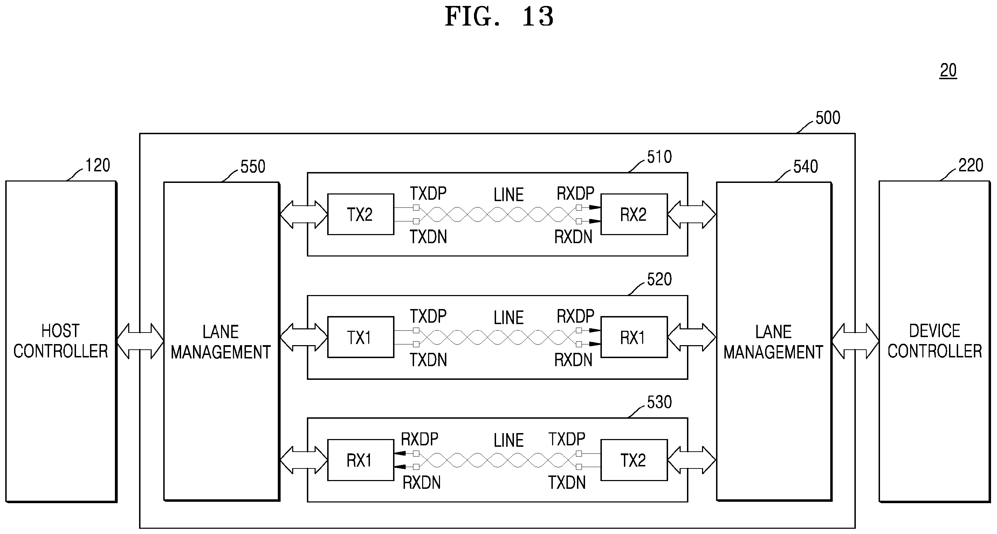

In some example embodiments, when the storage system 10 is a mobile device, the link layers 112 and 212 may be defined by the "UniPro" specification, and the physical layer 111 and 211 may be defined by the "M-PHY" specification. UniPro and M-PHY are interface protocols proposed by a mobile industry processor interface (MIPI) alliance. In some example embodiments, each of the link layers 112 and 212 may include a physical adapted layer. The physical adapted layer may control the physical layers 111 and 211 such as managing a symbol of data or managing power. An interface between the host 100 and the storage device 200 may be described in detail with reference to FIG. 13.

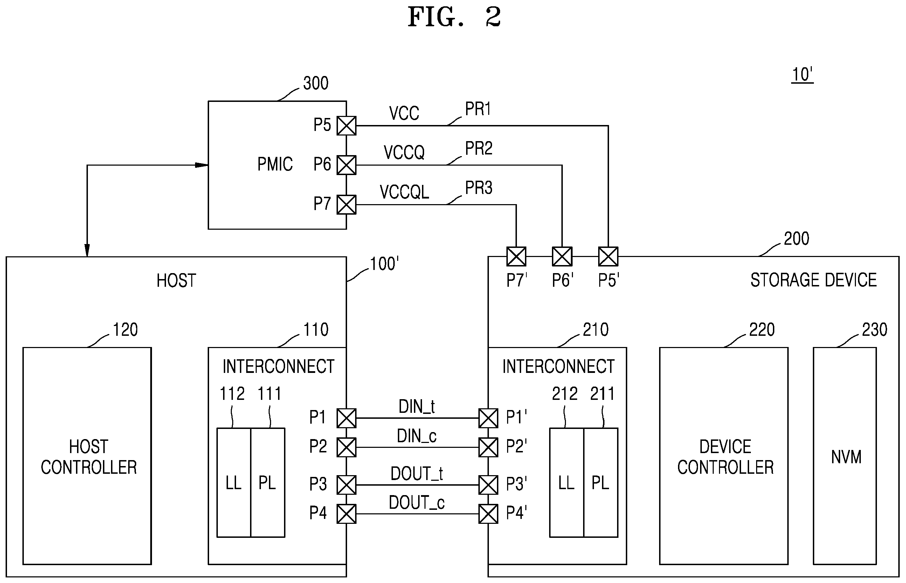

FIG. 2 is a block diagram illustrating a storage system 10' according to some example embodiments.

Referring to FIG. 2, unlike in FIG. 1, the PMIC 300 may be arranged outside a host 100'. The host 100' may control the PMIC 300 by providing the PMIC command to the PMIC 300.

In the present specification, descriptions of the storage system 10 including the host 100 and the storage device 200 may also be applied to the storage system 10' including the host 100' and a storage device 200.

FIG. 3 is a block diagram illustrating a storage system 10 according to some example embodiments.

Referring to FIG. 3, the host 100 may include the interconnect unit 110, a clock generator 130, and the PMIC 300, and the interconnect unit 110 may include a transmitter TX1 and a receiver RX1.

The clock generator 130 may generate a reference clock signal REF_CLK. The host 100 may transmit the reference clock signal REF_CLK to the storage device 200 through a pin P8. The clock generator 130 may include a phase-locked loop (PLL) circuit or a delay-locked loop (PLL) circuit. In some example embodiments, the clock generator 130 may be included in the interconnect unit 110.

The interconnect unit 110 may operate based on the reference clock signal REF_CLK generated by the clock generator 130. For example, the transmitter TX1 may transmit data based on the reference clock signal REF_CLK, and the receiver RX1 may receive data based on the reference clock signal REF_CLK. However, example embodiments are not limited thereto, and the clock generator 130 may generate an internal clock signal by changing the frequency and the phase of the reference clock signal REF_CLK, and the interconnect unit 110 may also operate based on the internal clock signal. In some example embodiments, when a data transmission rate changing operation is performed, the frequency of the internal clock signal may be changed, and the transmitter TX1 and the receiver RX1 may transmit/receive data in response to the internal clock signal having the changed frequency. Although the transmitter TX1 and the receiver RX1 may operate based on the same clock signal, the transmitter TX1 and the receiver RX1 may also operate based on different clock signals.

The storage device 200 may receive the reference clock signal REF_CLK from the host 100 through a pin P8'. The interconnect unit 210 may include a transmitter TX2 and a receiver RX2. The interconnect unit 210 may operate based on the reference clock signal REF_CLK. For example, the transmitter TX2 may transmit data based on the reference clock signal REF_CLK, and the receiver RX2 may receive data based on the reference clock signal REF_CLK. However, example embodiments are not limited thereto, and the storage device 200 may further include a clock generator (not shown). The clock generator (not shown) may be included in the interconnect unit 210. The clock generator (not shown) may generate an internal clock signal by changing the frequency of the reference clock signal REF_CLK, and the interconnect unit 210 may also operate based on the internal clock signal. In some example embodiments, when a data transmission rate changing operation is performed, the frequency of the internal clock signal may be changed, and the transmitter TX2 and the receiver RX2 may transmit/receive data in response to the internal clock signal having the changed frequency. Although the transmitter TX2 and the receiver RX2 may operate based on the same clock signal, the transmitter TX2 and the receiver RX2 may also operate based on different clock signals. Unlike in FIG. 3, the storage device 200 may generate an additional source clock signal rather than the reference clock signal REF_CLK and may generate an internal clock signal by changing the phase and frequency of the source clock signal.

The device controller 220 may include a regulator 221, a switching circuit 222, and a logic circuit 223.

The regulator 221 may receive the VCCQ voltage and generate a regulated voltage Vr by regulating the voltage level of the VCCQ voltage. For example, the regulator 221 may generate the regulated voltage Vr by stepping down the VCCQ voltage. However, example embodiments are not limited thereto, and the regulator 221 may also generate the regulated voltage Vr by stepping up the VCCQ voltage. For example, the regulator 221 may be a low drop out (LDO) regulator.

The switching circuit 222 may receive the regulated voltage Vr from the regulator 221. The switching circuit 222 may receive the VCCQL voltage supplied from the host 100 through the pin P7' without going through the regulator 221. For example, the switching circuit 222 may receive the VCCQL voltage directly. Magnitudes of the regulated voltage Vr and the VCCQL voltage may be the same or different from each other.

The switching circuit 222 may select one of the regulated voltage Vr and the VCCQL voltage to output the selected one (of the regulated voltage Vr and the VCCQL) as a driving voltage Vd. For example, the switching circuit 222 may output the regulated voltage Vr as the driving voltage Vd during the initialization operation, and when the initialization operation is completed, the switching circuit 222 may output the VCCQL voltage as the driving voltage Vd. In some example embodiments, the voltage level of the VCCQL voltage may be determined based on the data transmission rate between the host 100 and the storage device 200. For example, the storage device 200 may provide voltage level information to the host 100 during the initialization operation, and when the initialization operation is completed, the host 100 may provide the VCCQL voltage having the voltage level mapped to a default data transmission rate to the storage device 200.

In some example embodiments, while the regulator 221 regulates the voltage level of the VCCQL voltage, power consumption may occur. According to some example embodiments, the switching circuit 222 may omit voltage conversion of the VCCQ voltage using the VCCQL voltage directly as a driving voltage so that enhanced (or improved) power efficiency may be provided. The driving voltage Vd may be supplied to the interconnect unit 210 and/ or the logic circuit 223. The transmitter TX2 and the receiver RX2 included in the interconnect unit 210 may transmit/receive data based on the driving voltage Vd.

The logic circuit 223 may refer to circuits included in the device controller 220 to process an instruction or a request provided from the host 100.

In some example embodiments, when the data transmission rate becomes faster by the data transmission rate changing operation, the host 100 may increase the voltage level of the VCCQL voltage based on the voltage level information. The host 100 may increase the voltage level of the VCCQL voltage, thereby enhancing (or increasing) a data transmission/receiving speed of the transmitter TX2 and the receiver RX2 included in the interconnect unit 210, and improving data integrity. Furthermore, when the data transmission rate becomes faster, the amount of data to be processed by the device controller 220 may increase so that the processing speed of the device controller 220 may be enhanced (or improved) by increasing the voltage level of the VCCQL voltage.

In some example embodiments, when the data transmission rate becomes slower, the host 100 may decrease (or reduce) the voltage level of the VCCQL voltage based on the voltage level information. The host 100 may decrease the voltage level of the VCCQL voltage, thereby reducing power consumed by the transmitter TX2 and the receiver RX2 included in the interconnect unit 210, and the device controller 220. For example, the storage system 10 may regulate the voltage level of the VCCQL voltage according to the data transmission rate so that enhanced (or improved) power efficiency may be provided.

FIG. 4 is a diagram illustrating an operating method of the storage system 10 according to some example embodiments. FIG. 4 may be described with reference to FIGS. 1 and 3.

Referring to FIG. 4, the host 100 and the storage device 200 may perform an initialization operation (operation S410) and a data transmission rate changing operation (operation S420).

In some example embodiments, when the initialization operation (operation S410) is performed, the host 100 may provide a VCCQ voltage to the storage device 200 (operation S411). The storage device 200 may generate a regulated voltage Vr by regulating the VCCQ voltage and may use the regulated voltage Vr as a driving voltage Vd. The initialization operation may be performed when the storage system 10 is booted or an error recovery operation is performed.

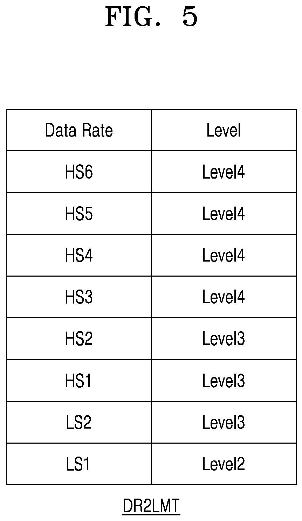

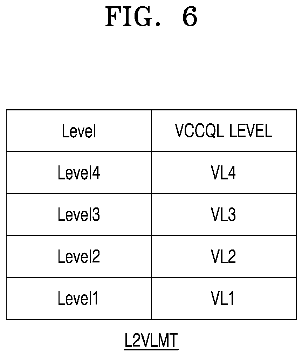

The host 100 may provide a voltage level information request VL_REQ (operation S412). The storage device 200 may provide a voltage level information response VL_CNF to the host 100 in response to receiving a voltage level information request VL_REQ (operations S413). The voltage level information response VL_CNF may include voltage level information. The voltage level information may be information about voltage levels of the VCCQL voltage mapped to data transmission rates. For example, the voltage level information may include mapping information (e.g., DR2LMT of FIG. 5) about data transmission rates and levels and mapping information (e.g., L2VLMT of FIG. 6) about levels and voltage levels. Although it has described that all of mapping information (e.g., DR2LMT of FIG. 5) about data transmission rates and levels, and mapping information (e.g., L2VLMT of FIG. 6) about levels and voltage levels are included in one voltage level information response VL_CNF, example embodiments are not limited thereto. For example, each of the mapping information (e.g., DR2LMT of FIG. 5) about data transmission rates and levels, and mapping information (e.g., L2VLMT of FIG. 6) about levels and voltage levels may be dispersed into and included in a plurality of voltage level information responses VL_CNF transmitted from the storage device 200, but example embodiments are not limited thereto.

The host 100 may provide the VCCQL voltage having a voltage level LV1 mapped to a default data transmission rate, to the storage device 200 (operation S414). In some example embodiments, when the initialization operation is performed, the host 100 and the storage device 200 may transmit/receive data based on the default data transmission rate. The host controller 120 may identify the voltage level LV1 mapped to the data transmission rate based on the voltage level information and may control the PMIC 300 so that the VCCQL voltage may have the voltage level LV1. For example, the host 100 may determine an initial voltage level of the VCCQL voltage after the initialization operation is completed, as the voltage level LV1 mapped to the default data transmission rate.

In some example embodiments, when the initialization operation (operation S410) is performed, the storage device 200 may separately provide the initial voltage level information about the initial voltage level of the VCCQL voltage after the initialization operation is completed, to the host 100. The host 100 may determine the voltage level of the VCCQL voltage based on the initial voltage level information.

The storage device 200 may switch the driving voltage from the regulated voltage Vr to the VCCQL voltage (operation S415). The storage device 200 may use the VCCQL voltage supplied from the host 100 without voltage conversion directly as the driving voltage, thereby providing enhanced (or improved) power efficiency.

In some example embodiments, when the data transmission rate changing operation (S420) is performed, the host 100 may provide a data transmission rate changing request DRC_REQ to the storage device 200 (operation S421). The data transmission rate changing request DRC_REQ may include information about a first data transmission rate DR1. For example, the host 100 may request the storage device 200 to change the data transmission rate to the first data transmission rate DR1.

The storage device 200 may provide the data transmission rate changing response DRC_CNF to the host 100 (operation S422). The host 100 and the storage device 200 may change the data transmission rate. For example, the host 100 and the storage device 200 may change the data transmission rate by adjusting the frequency of an internal clock signal used in data transmission/receiving.

The host 100 may provide the VCCQL voltage having a second voltage level VL2 mapped to the first data transmission rate DR1 (operation S423). For example, the host controller 120 may identify the second voltage level VL2 mapped to the first data transmission rate DR1 based on the voltage level information and may control the PMIC 300 so that the VCCQL voltage may have the second voltage level LV2. Although, in FIG. 4, the host 100 changes the voltage level of the VCCQL voltage to the second voltage level VL2 after receiving the data transmission rate changing response DRC_CNF, example embodiments are not limited thereto. For example, the host 100 may also provide the data transmission rate changing request DRC_REQ to the storage device 200 after changing the VCCQL voltage to the second voltage level VL2.

According to some example embodiments, the voltage level of the VCCQL voltage may be changed to a voltage level mapped to the data transmission rate, and the storage device 200 may use the VCCQL voltage directly as a driving voltage so that enhanced (or improved) power efficiency may be provided.

FIG. 5 is a diagram illustrating a mapping table DR2LMT about a data transmission rate and a level. FIG. 6 is a diagram illustrating a mapping table L2VLMT about a level and a voltage level.

Referring to FIG. 5, the mapping table DR2LMT about the data transmission rate and the level may include information about a plurality of data transmission rates and levels. A plurality of data transmission rates LS1, LS2, and HS1 to HS6 may be grouped into low speed data transmission rates LS1 and LS2 and high speed data transmission rates HS1 to HS6. The group of the low speed data transmission rates LS1 and LS2 may be referred to as a low speed mode, and the group of the high speed data transmission rates HS1 to HS6 may be referred to as a high speed mode.

In the low speed mode, the interconnect units 110 and 210 may transmit/receive data using a non-return-to-zero (NRZ) method or a pulse-width-modulation (PWM) method. In the high speed mode, the interconnect units 110 and 210 may transmit/receive data based on the reference clock signal REF_LCK or the internal clock signal.

The plurality of data transmission rates LS1, LS2, and HS1 to HS6 may be mapped to levels Level1 to Level4. Although, in FIG. 5, Level1 is not mapped to the data transmission rates LS1, LS2 and HS1 to HS6, example embodiments are not limited thereto.

The storage device 200 may store a mapping table DR2LMT between the plurality of data transmission rates LS1, LS2, and HS1 to HS6 and the levels Level1 to Level4. The storage device 200 may provide the mapping table DR2LMT in response to receiving a voltage level information request (e.g., VL_REQ of FIG. 4) of the host 100. The mapping table DR2LMT may be included in a voltage level information response (e.g., VL_CNF of FIG. 4).

Referring to FIG. 6, the mapping table L2VLMT about a level and a voltage level may include information about a plurality of levels Level1 to Level4, and voltage levels VL1 to VL4.

Each of the voltage levels VL1 to VL4 may be lower than the voltage level of the VCCQ voltage or the voltage level of the VCC voltage, however, example embodiments are not limited thereto.

The storage device 200 may store the mapping table L2VLMT between a plurality of levels Level1 to Level4 and voltage levels VL1 to VL4. The storage device 200 may provide the mapping table L2VLMT in response to receiving the voltage level information request (e.g., VL_REQ of FIG. 4) of the host 100. The mapping table L2VLMT may be included in the voltage level information response (e.g., VL_CNF of FIG. 4).

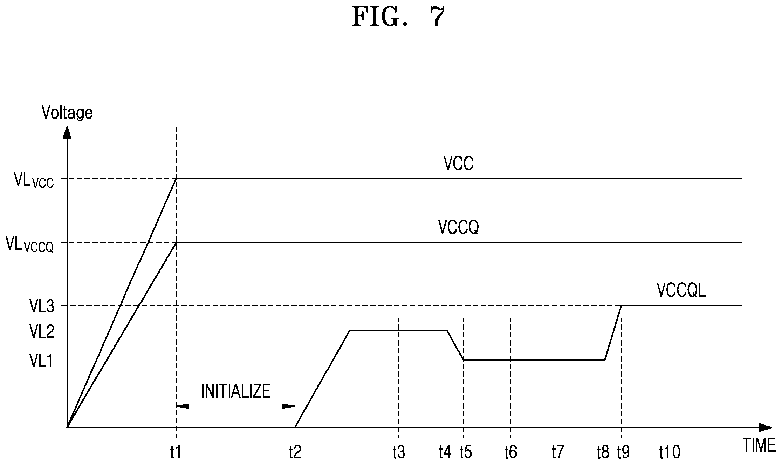

FIG. 7 is a diagram illustrating voltage levels of a VCC voltage, a VCCQ voltage, and a VCCQL voltage according to some example embodiments.

Referring to FIG. 7, at a time of t1, the voltage level of the VCC voltage may reach VL_{VCC}, and the voltage level of the VCCQ voltage may reach VL_{VCCQ}. However, example embodiments are not limited thereto, and a time at which the voltage level of the VCC voltage reaches VL_{VCC}, and a time at which the voltage level of the VCCQ voltage reaches VL_{VCCQ}, may be different from each other. VL_{VCC} may be greater than VL_{VCCQ}. After a time of t2, the storage device 200 may generate a regulated voltage by regulating the VCCQ voltage and may use the regulated voltage as a driving voltage.

An initialization operation may be performed from a time of t1 to a time of t2. In some example embodiments, when the initialization operation is performed, the storage device 200 may provide a voltage level information response (e.g., VL_CNF of FIG. 4) to the host 100. In some example embodiments, the storage device 200 may also provide initial voltage level information to the host 100. The initial voltage level information may be information about an initial voltage level of the VCCQ voltage after the initialization operation. In some example embodiments, when the initialization operation is completed, the host 100 and the storage device 200 may transmit/receive data based on the default data transmission rate.

At the time of t2, the host 100 may generate a VCCQL voltage having a voltage level VL1 mapped to the default data transmission rate based on the voltage level information. The host 100 may provide the generated VCCQL voltage to the storage device 200. The default data transmission rate may be DR1. In some example embodiments, the host 100 may generate a VCCQL voltage having the voltage level VL1 based on the initial voltage level information and may also provide the VCCQL voltage to the storage device 200. The storage device 200 may switch the driving voltage from the regulated voltage to the VCCQL voltage. The storage device 200 may use the VCCQL voltage directly as a driving voltage without voltage conversion of the VCCQL voltage.

From a time of t3 to a time of t4, the host 100 and the storage device 200 may perform a data transmission rate changing operation. For example, the host 100 may provide a data transmission rate changing request (e.g., DRC_REQ of FIG. 4) to the storage device 200. The storage device 200 may provide the data transmission rate changing response (e.g., DRC_CNF of FIG. 4) to the host 100. The data transmission rate may be changed from DR1 to DR2 through the data transmission rate changing operation. DR2 may be smaller than DR1.

At the time of t4, the host 100 may change the voltage level of the VCCQL voltage to VL2 based on the voltage level information. For example, the host 100 may obtain a voltage level VL2 mapped to the data transmission rate DR2 changed by searching the voltage level information after the data transmission rate changing operation is completed, and may generate a VCCQL voltage to have the voltage level VL2. VL2 may be smaller than VL1. However, example embodiments are not limited thereto, and VL2 may be the same as or greater than VL1.

In some example embodiments, the host 100 and the storage device 200 may perform the data transmission rate changing operation from a time of t5 to a time of t6 rather than performing the data transmission rate changing operation from the time of t3 to the time of t4. For example, the host 100 may also perform the data transmission rate changing operation after the voltage level of the VCCQL voltage is changed to VL2.

From a time of t7 to a time of t8, the host 100 and the storage device 200 may perform the data transmission rate changing operation. For example, the host 100 may provide a data transmission rate changing request (e.g., DRC_REQ of FIG. 4) to the storage device 200. The storage device 200 may provide the data transmission rate changing response (e.g., DRC_CNF of FIG. 4) to the host 100. The data transmission rate may be changed from DR2 to DR3 through the data transmission rate changing operation. In some example embodiments, DR3 may be greater than DR2, and DR3 may also be greater than DR1, but example embodiments are not limited thereto.

At the time of t8, the host 100 may change the voltage level of the VCCQL voltage to VL3 based on the voltage level information. For example, the host 100 may obtain a voltage level VL3 mapped to the data transmission rate DR3 changed by searching the voltage level information after the data transmission rate changing operation is completed, and may generate a VCCQL voltage to have the voltage level VL3. In some example embodiments, VL3 may be greater than VL2, and VL3 may also be greater than VL1, but example embodiments are not limited thereto. For example, VL3 may be the same as or smaller than VL2, but example embodiments are not limited thereto.

In some example embodiments, the host 100 and the storage device 200 may perform the data transmission rate changing operation from the time of t7 to the time of t8 rather than performing the data transmission rate changing operation from a time of t9 to a time of t10. For example, the host 100 may also perform the data transmission rate changing operation after the voltage level of the VCCQL voltage is changed to VL3.

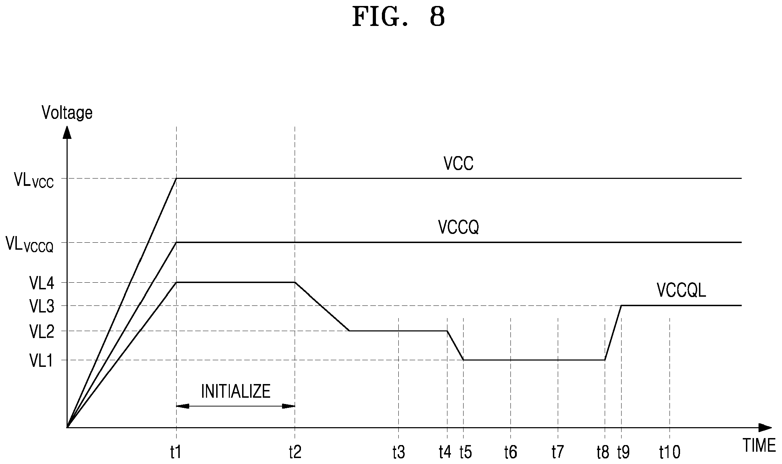

FIG. 8 is a diagram illustrating voltage levels of the VCC voltage, the VCCQ voltage, and the VCCQL voltage according to some example embodiments.

Referring to FIG. 8, unlike in FIG. 7, the host 100 may provide the VCCQL voltage having a voltage level VL4 to the storage device 200 at the time of t1.

In some example embodiments, when the initialization operation is performed, the storage device 200 may generate a driving voltage based on the VCCQL voltage rather than the VCCQ voltage. For example, the storage device 200 may generate a regulated voltage by regulating the VCCQL voltage, may use the regulated voltage as a driving voltage, or may use the VCCQL voltage directly as a driving voltage. VL4 may be greater than VL3, however, example embodiments are not limited thereto.

In some example embodiments, when the initialization operation is completed, the host 100 may change the voltage level of the VCCQL voltage to VL1. For example, the host 100 may change the voltage level of the VCCQL voltage to VL1 based on the voltage level information or the initial voltage level information.

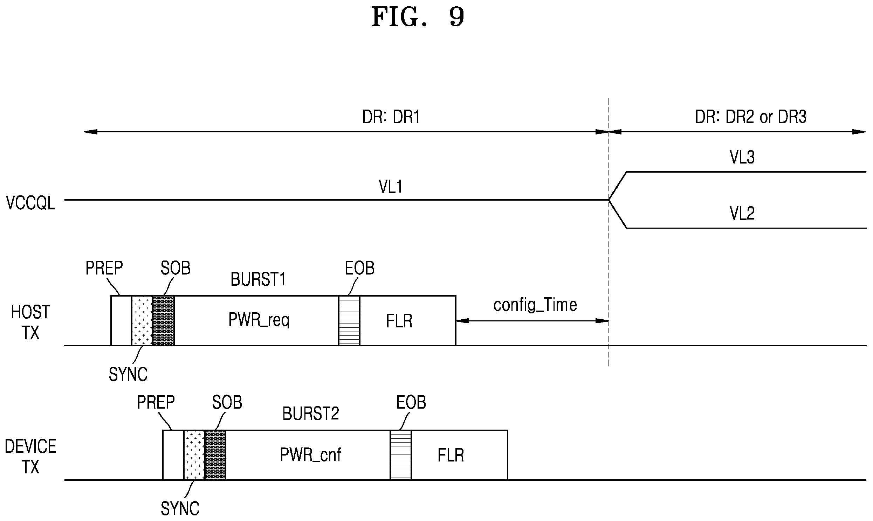

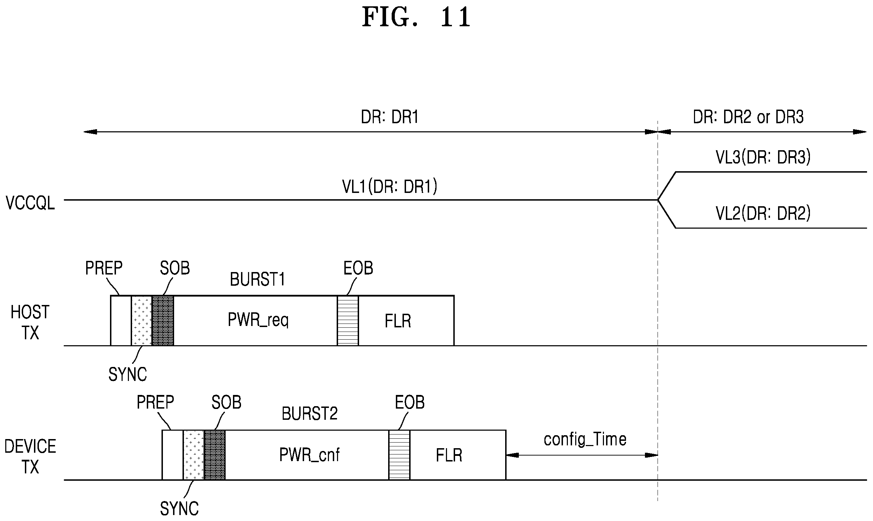

FIG. 9 is a diagram illustrating a data transmission rate changing operation between the host 100 and the storage device 200 according to some example embodiments. For example, FIG. 9 illustrates data transmitted to a line LINE through a host transmitter HOST TX and a device transmitter DEVICE TX to adjust a data transmission rate. Although not shown in FIG. 9, as will be described below with reference to FIG. 11, the host transmitter HOST TX may be connected to the device receiver DEVICE RX through the line LINE, and the device transmitter DEVICE TX may be connected to the host receiver HOST RX through the line LINE. Thus, although data transmitted through the device transmitter DEVICE RX may be the same as data transmitted through the host transmitter HOST TX, a phase difference may occur as much as a line delay. Data transmitted through the host receiver HOST RX may be the same as data transmitted through the device transmitter DEVICE TX, however, a phase difference may occur as much as a line delay.

In FIG. 9, the host transmitter HOST TX or the device transmitter DEVICE TX may be in at least one of a power saving state or a burst state. The power saving state may be a state for minimizing (or reducing) consumed power and may be a state in which the line LINE is driven with a negative differential line voltage DIF-N or a zero differential line voltage DIF-Z. The power saving state may be one of a stall state, a sleep state, a hibernating state HIBERN8, a disabled state, and an unpowered state. In some example embodiments, it may be assumed that the power saving state is a stall state. The burst state may be a state in which data is transmitted to a line, and may be a state in which the line is driven with a positive differential line voltage DIF-P. The burst state may include a high speed burst HS-BURST state in which data is transmitted in a high speed mode, and a low speed burst LS-BURST state in which data is transmitted in a low speed mode. The line LINE may have a DIF-X state not a DIF-Q state, a DIF-N state, or a DIF-P state indicating a high impedance state. Here, a differential line voltage may be defined as a value obtained by subtracting a voltage of a line connected to a negative node from a voltage of a line connected to a positive node.

Referring to FIG. 9, a bit sequence transmitted in the burst state through the line may be referred to as burst BURST. The burst BURST may include a preparation period PREPARE, a synchronization period SYNC, a start-of-burst (SOB) period, a power mode changing request PWR_REQ or a power mode changing response PWR_CNF, an end-of-burst (EOB) period, and a filler period FLR. The preparation period PREPARE may be a period in which the line is driven with the positive differential line voltage DIF-P.

The synchronization period SYNC may be a period in which a symbol for clock synchronization is transmitted. The SOB period may be a period in which the symbol is transmitted before (or immediately before) the power mode changing request PWR_req or the power mode changing response PWR_cnf. For example, MK0 on the M-PHY specification may be transmitted in the SOB period. The power mode changing request PWR_req may include information requesting a change of data transmission rate. The power mode changing request PWR_req may correspond to the data transmission rate changing request DRC_REQ of FIG. 4. The power mode changing response PWR_cnf may include information responding to the power mode changing request PWR_req. The power mode changing request PWR_cnf may correspond to the data transmission rate changing response DRC_CNF of FIG. 4. The EOB period may be a period in which at least one bit indicating the end of burst is transmitted. The EOB period may be a period in which the line is driven with the negative differential line voltage DIF-N. The filler period FLR may be a period in which at least one specific pattern is transmitted after the EOB period.

Referring to FIG. 9, the host 100 may transmit a first burst BURST1 based on the data transmission rate DR1 through the host transmitter HOST TX when the data transmission rate changing operation is performed. The first burst BURST1 may include a power mode changing request PWR_req that requests the data transmission rate to be changed from DR1 to DR2 or DR3. DR3 may be greater than DR1, and DR2 may be smaller than DR1, but example embodiments are not limited thereto.

The storage device 200 may transmit a second burst BURST2 based on the data transmission rate DR1 through the device transmitter DEVICE TX when the data transmission rate changing operation is performed. The second burst BURST2 may include a power mode changing response PWR_cnf corresponding to the power mode changing request PWR_req.

The host 100 may adjust the data transmission rate to DR2 during a configuration time config_time when the filler period FLR of the first burst BURST1 is terminated. For example, when the filler period FLR is terminated, the clock generator 130 may adjust the data transmission rate to DR2 or DR3 by changing the frequency of the internal clock signal. During the configuration time config_time, data may not be transmitted through the line LINE connected to the host transmitter HOST_TX, and the data transmission rate may be adjusted within the configuration time config_time.

The storage device 200 may adjust the data transmission rate to DR2 or DR3 when the filler period FLR included in the second burst BURST2 is terminated. For example, when the filler period FLR is terminated, the storage device 200 may adjust the data transmission rate to DR2 or DR3 by changing the frequency of the internal clock signal.

As shown in FIG. 9, the host 100 may change the voltage level of the VCCQL voltage after the configuration time config_time has elapsed. For example, when the data transmission rate is changed from DR1 to DR2 during the configuration time config _time, the host 100 may obtain a voltage level VL2 mapped to the data transmission rate DR2 based on the voltage level information after the configuration time config_time has elapsed and may change the voltage level of the VCCQL voltage to VL2. In some example embodiments, when the data transmission rate is changed from DR1 to DR3 during the configuration time config _time, the host 100 may obtain a voltage level VL3 mapped to the data transmission rate DR3 based on the voltage level information after the configuration time config_time has elapsed and may change the voltage level of the VCCQL voltage to VL3.

According to some example embodiments, the voltage level of the VCCQL voltage may be changed after the configuration time config _time, so that a time at which the frequency of the internal clock signal is stabilized, may be obtained.

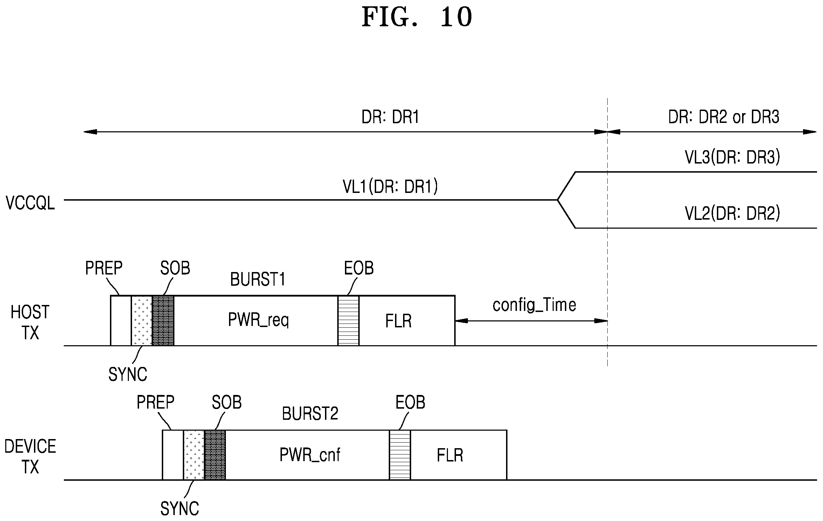

FIG. 10 is a diagram illustrating a data transmission rate changing operation between the host 100 and the storage device 200 according to some example embodiments.

Referring to FIG. 10, unlike in FIG. 9, the host 100 may change the voltage level of the VCCQL voltage during the configuration time config_time. For example, the host 100 may change the voltage level of the VCCQL voltage when the filler period FLR of the second burst BURST2 received from the device transmitter DEVICE TX is terminated.

According to some example embodiments, even before the configuration time config_time has elapsed, when the filler period FLR of the second burst BURST2 is terminated, the voltage level of the VCCQL voltage is changed so that a time at which the voltage level of the VCCQL voltage is changed, may be reduced.

FIG. 11 is a diagram illustrating a data transmission rate changing operation between the host 100 and the storage device 200 according to some example embodiments.

Referring to FIG. 11, unlike in FIG. 9, the host 100 and the storage device 200 may adjust the data transmission rate to DR2 during the configuration time config_time when the filler period FLR of the second burst BURST2 is terminated. For example, the clock generator 130 of the host 100 may change the frequency of the internal clock signal to adjust the data transmission rate to DR2 or DR3 when the filler period FLR of the second burst BURST2 is terminated. Additionally, or alternatively, the storage device 200 may change the frequency of the internal clock signal to adjust the data transmission rate to DR2 or DR3 when the filler period FLR of the second burst BURST2 is terminated.

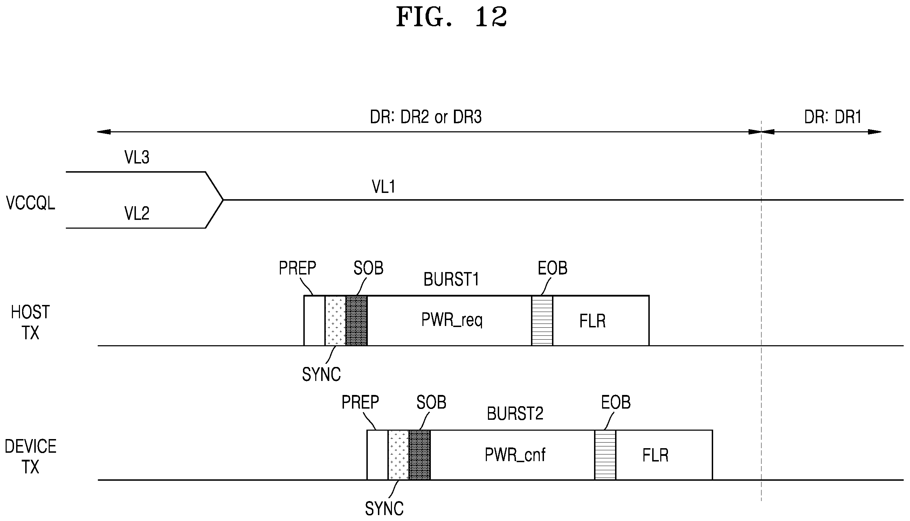

FIG. 12 is a diagram illustrating a data transmission rate changing operation between the host 100 and the storage device 200 according to some example embodiments.

Referring to FIG. 12, the host 100 may provide the first burst BURST1 to the storage device 200 after the voltage level of the VCCQL voltage is changed.

In some example embodiments, when the first burst BURST1 requests the host 100 to change the data transmission rate from DR3 to DR1, the host 100 may change the voltage level of the VCCQL voltage from VL3 to VL1 before providing the first burst BURST1. DR3 may be greater than DR1, and VL3 may be greater than VL1, but example embodiments are not limited thereto.

In some example embodiments, when the first burst BURST1 requests the host 100 to change the data transmission rate from DR2 to DR1, the host 100 may change the voltage level of the VCCQL voltage from VL2 to VL1 before providing the first burst BURST1. DR2 may be smaller than DR1, and VL2 may be smaller than VL1, but example embodiments are not limited thereto.

FIG. 13 illustrates an interface 20 between the host and the storage device according to some example embodiments.

Referring to FIG. 13, the interface 20 may include a link 500 between the host controller 120 and a device controller 220, and the link 500 may include a plurality of lanes 510, 520, and 530. The link 500 may include at least one lane corresponding to each direction, and the number of lanes in each direction are not required to be symmetrical. For example, the link 500 may include two lanes 510 and 520 corresponding to a first direction from the host controller 120 to the device controller 220, and one lane 530 corresponding to a second direction from the device controller 220 to the host controller 120, however, example embodiments are not limited thereto. For example, two lanes 510 and 520 corresponding to the first direction may constitute a first sub link, and one lane 530 corresponding to the second direction may constitute a second sub link.

The interface 20 may support a plurality of lanes. Each of the lanes 510, 520, and 530 may be a unidirectional lane, a single-signal lane, and/or a transmission channel on which information is transmitted. For example, the lane 520 may include a transmitter TX1, a receiver RX1, a line LINE for point-to-point interconnecting between the transmitter TX1, and the receiver RX1. For example, the transmitter TX1 may be connected to a pin TXDP corresponding to a positive node of a differential signal and a pin TXDN corresponding to a negative node of the differential signal, and the receiver RX1 may be connected to a pin RXDP corresponding to the positive node of the differential signal and a pin RXDN corresponding to the negative node of the differential signal. The line LINE may include two differentially-routed wires connecting pins TXDP and RXDP and TXDN and RXDN of the transmitter TX1 and the receiver RX1, and these wires may correspond to transmission lines.

The link 500 may further include lane management units 540 and 550 for providing a bidirectional data transmission function. FIG. 13 illustrates that the lane management unit 550 and the host controller 120 are separated from each other, however, inventive concepts are not limited thereto, and the lane management unit 550 may be included in the host controller 120. Similarly, FIG. 13 illustrates that the lane management unit 540 and the device controller 220 are separated from each other, however, inventive concepts are not limited thereto, and the lane management unit 540 may be included in the device controller 220.

Referring to FIG. 13, a transmitter of the host 100 and a receiver of the storage device 200 may constitute one lane. However, the number of transmitters and receivers of the host 100 may be different from the number of transmitters and receivers of the storage device 200. Additionally, or alternatively, the capability of the host 100 may be different from the capability of the storage device 200. Thus, the host 100 and the storage device 200 may recognize a physically-connected lane and may perform processing for receiving information about an opponent's device. For example, the host 100 and the storage device 200 may perform a link startup operation before exchanging data. In the present specification, the link startup operation may be referred to as an initialization operation, for example, a link layer initialization operation. By performing the link startup operation, the host 100 and the storage device 200 may exchange and recognize information about the number of transmitters and receivers, information about a physically-connected lane, information about the capability of an opponent's device, and the like, but example embodiments are not limited thereto. According to some example embodiments, when the link startup operation is performed, the storage device 200 may provide voltage level information to the host 100. For example, the storage device 200 may provide information about a plurality of voltage levels of the VCCQL voltage corresponding to a plurality of data transmission rates, to the host 100. In some example embodiments, when the link startup operation is performed, the storage device 200 may also provide initial voltage level information to the host 100. The link startup operation may be performed during a booting operation of the storage system 10. Furthermore, the link startup operation may also be performed even during an operation of recovering an error in a linkup state.

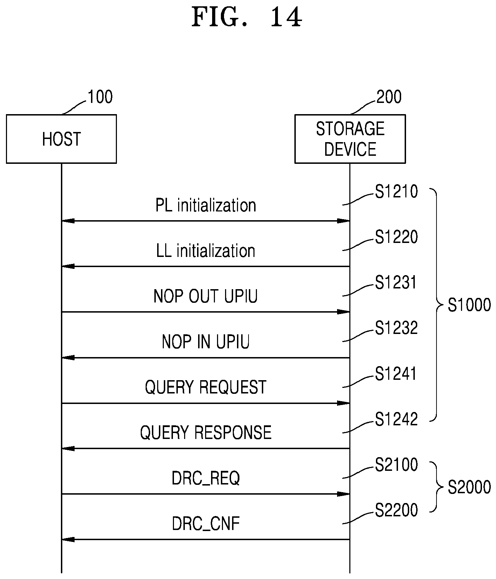

After the link startup operation is completed, the host 100 and the storage device 200 may be set in a linkup state in which the host 100 and the storage device 200 may exchange data to each other (or may exchange data to each other stably). In the linkup state, the host 100 and the storage device 200 may transmit/receive data based on the default data transmission rate. In the linkup state, the host 100 may provide the VCCQL voltage having a voltage level corresponding to the default data transmission rate, to the storage device 200. In some example embodiments, in the linkup state, the host 100 may determine the VCCQL voltage based on the initial voltage level. The initialization operation may be described in detail below with reference to FIG. 14.

FIG. 14 is a flowchart illustrating an initialization operation and a data transmission rate changing operation between the host 100 and the storage device 200 according to some example embodiments.

Referring to FIGS. 1 and 14, the host 100 and the storage device 200 may perform an initialization operation (S1000) and a data transmission rate changing operation (S2000). The initialization operation (S1000) may include a physical layer initialization operation (S1210), a link layer initialization operation (S1220), NOP exchanging operations (S1231, S1232), and QUERY exchanging operations (S1241, S1242).

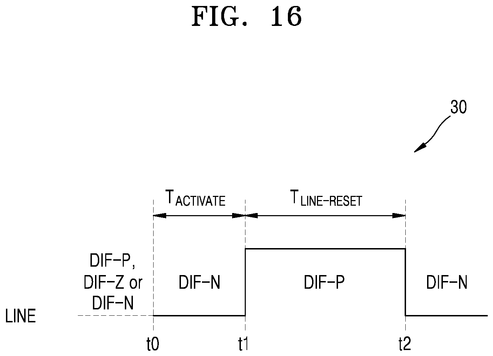

In some example embodiments, when the physical layer initialization operation (S1210) is performed, the host 100 and the storage device 200 may transmit/receive a line-reset signal. The line-reset signal may be described in detail below with reference to FIG. 16. In some example embodiments, the storage device 200 may provide voltage level information to the host 100 through the line-reset signal. For example, the storage device 200 may provide a plurality of line-reset signals having different T_{LINE-RESET} lengths from each other to the host 100, thereby providing information about voltage levels mapped to a plurality of data transmission rates. The length of T_{LINE-RESET} may correspond to the voltage level. In some example embodiments, the storage device 200 may provide initial voltage level information to the host 100 through the line-reset signal. For example, the storage device 200 may provide the line-reset signal having the length of T_{LINE-RESET} corresponding to the voltage level of the VCCQL voltage to the host 100 after the initialization operation is performed.

In some example embodiments, when the link layer initialization operation (S1220) is performed, the host 100 and the storage device 200 may perform a link startup operation. In some example embodiments, when the link layer initialization operation (S1220) is performed, the host 100 and the storage device 200 may perform a capability exchanging operation in which attributes of physical layers are set. In some example embodiments, when the capability exchanging operation is performed, the storage device 200 may provide a voltage level information response VL_CNF including information about voltage levels of the VCCQL voltage corresponding to the data transmission rates, e.g., voltage level information, to the host 100.

In some example embodiments, when the NOP exchanging operation is performed, the host 100 may provide NOP OUT UPIU to the storage device 200 (operation S1231), and the storage device 200 may provide NOP IN UPIU to the host 100. NOP OUT UPIU may be a format defined in the UFS specification and may include the voltage level information request VL_REQ of FIG. 4. NOP IN UPIU may be a format defined in the UFS specification and may include the voltage level information response VL_CNF of FIG. 4.

In some example embodiments, when the QUERY exchanging operation is performed, the host 100 may provide a QUERY request to the storage device 200 (operation S1241), and the storage device 200 may provide a QUERY response to the host 100 (operation S1242). The QUERY request may be a format defined in the UFS specification and may include the voltage level information request VL_REQ of FIG. 4. The QUERY response may be a format defined in the UFS specification and may include the voltage level information response VL_CNF of FIG. 4.

Through the initialization operation (operation S1000), the host 100 may receive voltage level information from the storage device 200. In some example embodiments, through the initialization operation (operation S1000), the host 100 may also receive initial voltage level information from the storage device 200.

The host 100 may determine the voltage level of the VCCQL voltage after the initialization operation (operation S1000) is completed, based on the voltage level information or the initial voltage level information. For example, the host 100 may obtain the voltage level mapped to a default data transmission rate based on the voltage level information and may generate a VCCQL voltage having the obtained voltage level. In some example embodiments, the host 100 may obtain an initial voltage level based on the initial voltage level information and may generate a VCCQL voltage having the initial voltage level. The storage device 200 may receive the VCCQL voltage and may use the VCCQL voltage directly as a driving voltage.

In some example embodiments, when the data transmission rate changing operation (operation S2000) is performed, the host 100 may provide a data transmission rate changing request DRC_REQ to the storage device 200 (operation S2100). The data transmission rate changing request DRC_REQ may correspond to the power mode changing request PWR_req of FIGS. 7 through 12. The storage device 200 may provide the data transmission rate changing response DRC_CNF to the host 100 (operation S2200). The data transmission rate changing response DRC_CNF may correspond to the power mode changing request PWR_req of FIGS. 7 through 12.

The host 100 may obtain a voltage level mapped to the data transmission rate changed based on the voltage level information, before or after the data transmission rate changing operation (operation S2000) is performed and may generate a VCCQL voltage having the obtained voltage level.

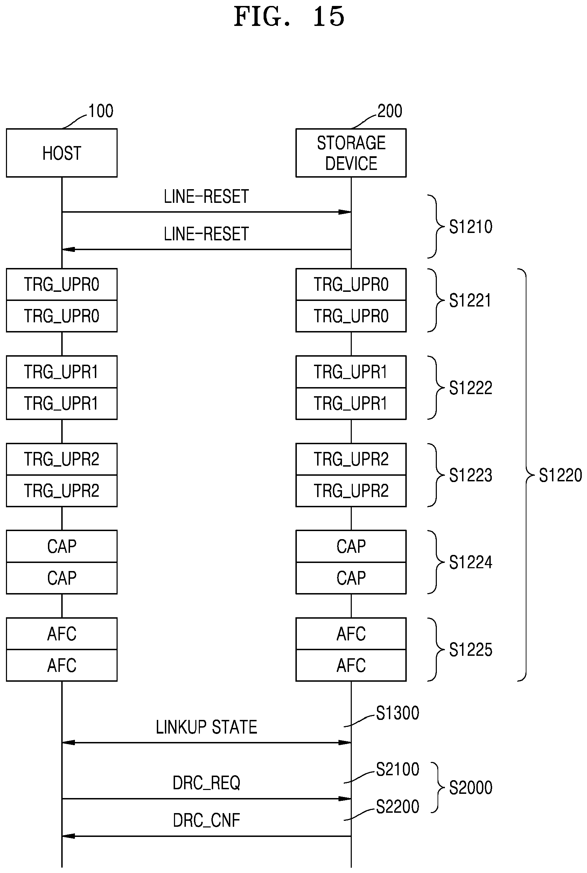

FIG. 15 is a diagram illustrating an initialization operation and a data transmission rate changing operation according to some example embodiments.

Referring to FIGS. 1, 12, and 13, in operation S1210, the host 100 may generate a line-reset signal LINE-RESET, reset transmitters of connected lanes, and provide information indicating that the transmitters are reset, to the storage device 200. Additionally, or alternatively, in operation S1210, the storage device 200 may receive the line-reset signal LINE-RESET, reset receivers of connected lanes, and provide information indicating that the receivers are reset, to the host 100. Through the line-reset operation, all attributes of physical layers 111 and 211 of the interconnect units 110 and 210 may be reset to a default value. The host 100 and the storage device 200 may exchange line-reset information each other.

Operation S1220 may be performed in a multi-phase handshake manner in which UniPro trigger events are exchanged between the host 100 and the storage device 200 to set initial link communication in both directions. Operation S1220 may be defined as certain phases, and a trigger event may be used in each operation, and each trigger event may be transmitted several times.

In operation S1221, connected lanes may be found between the host 100 and the storage device 200. In operation S1221, the host 100 may send a first trigger event TRG_UPR0 on all available transmission TX lanes. The host 100 may transmit the first trigger event TRG_UPR0 continuously until the host 100 receives a first trigger event message from the storage device 200. The first trigger event TRG_UPR0 sent by the host 100 may include a physical lane number of a transmission lane of the host 100 to which a corresponding trigger is transmitted.

Additionally, or alternatively, in operation S1221, the storage device 200 may send the first trigger event TRG_UPR0 on all available transmission lanes. The storage device 200 may transmit the first trigger event TRG_UPR0 continuously until the storage device 200 receives the first trigger event message from the host 100. The first trigger event TRG_UPR0 sent by the storage device 200 may include a physical lane number of a transmission lane of the storage device 200 to which a corresponding trigger is transmitted.

In operation S1222, lanes may be re-aligned. In operation S1222, the host 100 may send a second trigger event TRG_UPR1 on all available transmission lanes. The host 100 may transmit the second trigger event TRG_UPR1 continuously until the host 100 receives a second trigger event message from the storage device 200. The second trigger event TRG_UPR1 sent by the host 100 may include information about transmission lanes connected to the host 100.

Additionally, or alternatively, in operation S1222, the storage device 200 may send the second trigger event TRG_UPR1 on all available transmission lanes. The storage device 200 may transmit the second trigger event TRG_UPR1 continuously until the storage device 200 receives the second trigger event message from the host 100. The second trigger event TRG_UPR1 sent by the storage device 200 may include information about transmission lanes connected to the storage device 200.

In operation S1223, available connected lanes between the hosts 100 and the storage device 200 may be reflected on attributes of the physical layers 111 and 211 of the interconnect units 110 and 210. In operation S1222, the host 100 may send a third trigger event TRG_UPR2 on all available transmission lanes. The host 100 may transmit the third trigger event TRG_UPR2 continuously until the host 100 receives a message corresponding to the third trigger event TRG_UPR2 from the storage device 200. The third trigger event TRG_UPR2 sent by the host 100 may include logical lane numbers about transmission lanes connected to the host 100.

Additionally, or alternatively, in operation S1223, the storage device 200 may send the third trigger event TRG_UPR2 on all available transmission lanes. The storage device 200 may transmit the third trigger event TRG_UPR2 continuously until the storage device 200 receives a message corresponding to the third trigger event TRG_UPR2 from the host 100. The third trigger event TRG_UPR2 sent by the storage device 200 may include logical lane numbers about transmission lanes connected to the storage device 200.

As operation S1223 is performed, the host 100 and the storage device 200 may have identical logical lane numbers about available lanes.

In operation S1224, the host 100 and the storage device 200 may exchange and recognize information CAP about the capability of an opponent's device to communicate architecture requirements of the interconnect units 210 and 110. The architecture requirements of the interconnect units 210 and 110 may include, for example, a bandwidth, timers, a speed gear, termination/untermination, scrambling, and the like, but example embodiments are not limited thereto. Operation S1224 may be referred to as a capability exchanging operation. As the capability exchanging operation (S1224) is performed, the information CAP about the capability of the opponent's device may be collected in the interconnect units 210 and 110, and attributes of physical layers of the interconnect units 210 and 110 may be set according to the collected capability information CAP. In the present specification, the speed gear may be referred to as a data transmission rate. In some example embodiments, in the capability exchanging operation (S1224), the storage device 200 may provide voltage level information to the host 100.

In operation S1225, the host 100 and the storage device 200 may exchange a control frame AFC to each other to provide a reliable data link. To this end, the host 100 and the storage device 200 may send an initial data frame to the opponent's device, and a device that receives a data frame may send back the control frame AFC to a device that transmits the data frame. The control frame AFC may be configured differently from the data frame, and in order to recognize that the control frame AFC has been accurately received by the transmission device, the control frame AFC may be used to notify a buffer space of an available data link layer.

In operation S1300, when the link startup operation is completed, the host 100 and the storage device 200 may be set in a linkup state, and the host 100 and the storage device 200 may transmit/receive data stably. In the linkup state, the host 100 and the storage device 200 may transmit/receive data based on the default data transmission rate. In the linkup state, the host 100 may provide the VCCQL voltage having a voltage level corresponding to the default data transmission rate, to the storage device 200. In some example embodiments, in the linkup state, the host 100 may obtain a voltage level based on the initial voltage level information received in operation S1210 and may provide a VCCQL voltage having the obtained voltage level to the storage device 200.

In operation S2000, a data transmission rate changing operation between the host 100 and the storage device 200 may be performed. Descriptions of operation S2000 have been described in FIG. 14 and thus may be omitted.

According to some example embodiments, the voltage level of the VCCQL voltage is changed according to the data transmission rate and thus, power efficiency may be enhanced (or improved).

FIG. 16 is a timing diagram illustrating a line-reset signal LINE-RESET according to some example embodiments.

Referring to FIGS. 16 and 13 together, a voltage 30 of a line LINE may be driven in a DIF-P state having a positive differential line voltage, a DIF-N state having a negative differential line voltage, or a DIF-Z state having a nearly zero differential line voltage. Although not shown, the line LINE may have the DIF-X state rather than the DIF-Q state, the DIF-N or the DIF-P state indicating the high impedance state. Here, the differential line voltage may be defined as a value obtained by subtracting a voltage of a line connected to a negative node from a voltage of a line connected to a positive node.

The line LINE may correspond to an arbitrary line included in the interface 20, and for example, the line LINE may correspond to a differential input signal line through which differential input signals DIN_t and DIN_c of FIG. 1 are transmitted. For example, when the voltage level of the pin P1 to which the positive input signal DIN_t is applied, is higher than the voltage level of the pin P2 to which the negative input signal DIN_c is applied, the line LINE may be in a DIF-P state or logic high. For example, when the voltage level of the pin P1 to which the positive input signal DIN_t is applied, is lower than the voltage level of the pin P2 to which the negative input signal DIN_c is applied, the line LINE may be in a DIF-N state or logic low. For example, when the voltage level of the pin P1 to which the positive input signal DIN_t is applied, is almost the same (or is approximately the same) as the voltage level of the pin P2 to which the negative input signal DIN_c is applied, the line LINE may be in a DIF-Z state or ground state.

In an activate period T_{ACTIVATE} between t0 and t1, the line LINE may be driven with DIF-N. For example, the host 100 may drive a signal (e.g., an activate signal) transmitted through the line LINE in a DIF-N state, to indicate escape of a power saving state (e.g., a hibernating state HIBERN8) during the activate period T_{ACTIVATE}. The storage device 200 may escape the power saving state (e.g., a HIBERN8 state) in response to an activate signal.

In a line-reset period T_{LINE-RESET} between t1 and t2, the line LINE may be driven in a DIF-P state. For example, the host 100 may drive a signal (e.g., the line-reset signal LINE-RESET) transmitted through the line LINE in a DIF-P state, to indicate the line-reset operation during the line-reset period T_{LINE-RESET} period. The storage device 200 may perform line-reset of resetting the physical layer 211 of the interconnect unit 210 in response to the line-reset signal LINE-RESET.

The host 100 may provide the voltage level information request (e.g., VL_REQ of FIG. 4) to the storage device 200, to obtain the voltage level information from the storage device 200. In some example embodiments, an activate signal and a line-reset signal provided by the host 100 to the storage device 200 may correspond to the voltage level information request (e.g., VL_REQ of FIG. 4). The length of the activate signal or the line-reset signal may correspond to the data transmission rate. For example, the host 100 may provide a plurality of activate signals or line-reset signals having different lengths to the storage device 200 from each other, thereby requesting voltage levels mapped to a plurality of data transmission rates. In some example embodiments, the host 100 may provide the activate signal or the line-reset signal having a preset length to the storage device 200, thereby requesting information about the initial voltage level of the VCCQL voltage.

The storage device 200 may provide a voltage level information response (e.g., VL_CNF of FIG. 4) including the voltage level information to the host 100. In some example embodiments, the activate signal and the line-reset signal provided by the host 100 to the storage device 200 may correspond to the voltage level information response (e.g., VL_CNF of FIG. 4). The length of the activate signal or the line-reset signal may correspond to the voltage level. For example, the storage device 200 may provide a plurality of activate signals or line-reset signals having different lengths to the host 100 from each other, thereby providing information about a plurality of voltage levels to the host 100. In some example embodiments, the storage device 200 may provide the activate signal or the line-reset signal having a preset length to the host 100, thereby providing information about an initial voltage level of the VCCQL voltage.

The host 100 may generate a VCCQL voltage using the PMIC 300 according to Equation 1 based on the received line-reset signal.

[Equation 1] $VCCQL = VREF + k * {T}_{LINE - RESET}$

In Equation 1, VREF may represent a reference voltage, for example, may be approximately 0.5V, but example embodiments are not limited thereto. k may be a constant for determining resolution of VCCQL and T_{LINE-RESET} may be a line reset period.

However, example embodiments are not limited thereto, and the host 100 may also generate a VCCQL voltage based on the length of the received activate signal.

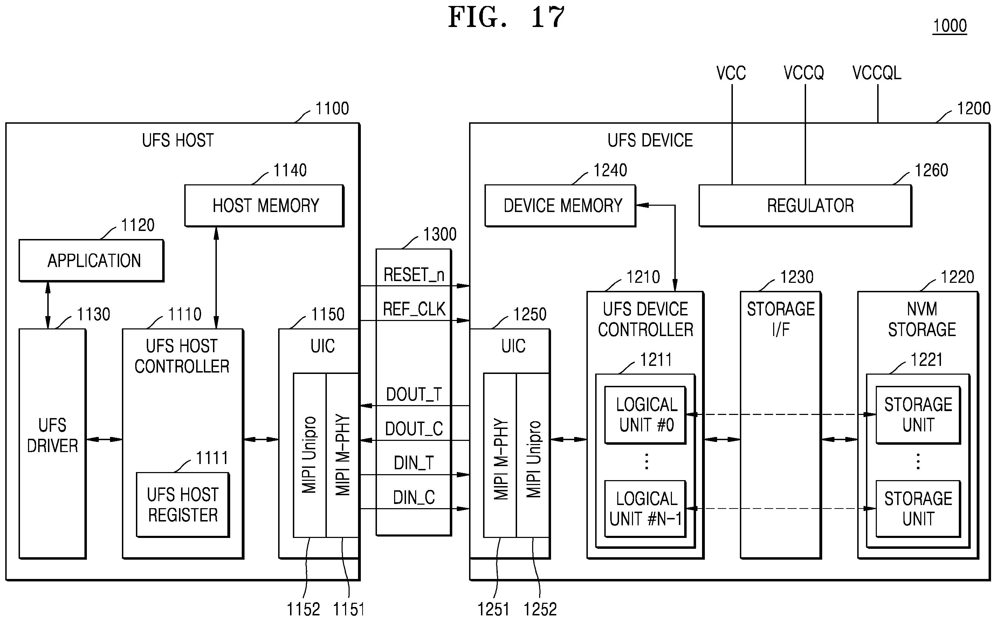

FIG. 17 is a diagram of a UFS system 1000 according to some example embodiments. The UFS system 1000 may be a system conforming to a UFS standard announced by Joint Electron Device Engineering Council (JEDEC) and include a UFS host 1100, a UFS device 1200, and a UFS interface 1300. The above description of the storage system 10, 10' of FIGS. 1 to 3 may also be applied to the UFS system 1000 of FIG. 17 within a range that does not conflict with the following description of FIG. 17.

Referring to FIG. 17, the UFS host 1100 may be connected to the UFS device 1200 through the UFS interface 1300. In some example embodiments, when the host 100 of FIG. 1 is an AP, the UFS host 1100 may be implemented as a portion of the AP. With reference to FIGS. 1-3, the UFS host controller 1110 may correspond to the host controller 120, the UFS device 1200 may correspond to the storage device 200 of FIG. 1, and a UFS device controller 1210 and an NVM storage 1220 may respectively correspond to the device controller 220 and/or the NVM 230 of FIG. 1.

The UFS host 1100 may include a UFS host controller 1110, an application 1120, a UFS driver 1130, a host memory 1140, and a UFS interconnect (UIC) layer 1150. The UFS device 1200 may include the UFS device controller 1210, the NVM storage1220, a storage interface 1230, a device memory 1240, a UIC layer 2250, and a regulator 1260. The NVM storage 1220 may include a plurality of storage units 1221. Although each of the storage units 1221 may include a V-NAND flash memory having a 2D structure or a 3D structure, each of the storage units 1221 may include another kind of NVM, such as PRAM and/or RRAM, but example embodiments are not limited thereto. The UFS device controller 1210 may be connected to the NVM storage 1220 through the storage interface 1230. The storage interface 1230 may be configured to comply with a standard protocol, such as Toggle or ONFI.

The application 1120 may refer to a program that wants to communicate with the UFS device 1200 to use functions of the UFS device 1200. The application 1120 may transmit input-output requests (IORs) to the UFS driver 1130 for input/output (I/O) operations on the UFS device 1200. The IORs may refer to a data read request, a data storage (or write) request, and/or a data erase (or discard) request, without being limited thereto.

The UFS driver 1130 may manage the UFS host controller 1110 through a UFS-host controller interface (UFS-HCI). The UFS driver 1130 may convert the IOR generated by the application 1120 into a UFS command defined by the UFS standard and transmit the UFS command to the UFS host controller 1110. One IOR may be converted into a plurality of UFS commands. Although the UFS command may basically be defined by an SCSI standard, the UFS command may be a command dedicated to the UFS standard.

The UFS host controller 1110 may transmit the UFS command converted by the UFS driver 1130 to the UIC layer 2250 of the UFS device 1200 through the UIC layer 1150 and the UFS interface 1300. During the transmission of the UFS command, a UFS host register 1111 of the UFS host controller 1110 may serve as a command queue (CQ).

The UIC layer 1150 on the side of the UFS host 1100 may include a mobile industry processor interface (MIPI) M-PHY 1151 and an MIPI UniPro 1152, and the UIC layer 2250 on the side of the UFS device 1200 may also include an MIPI M-PHY 1251 and an MIPI UniPro 1252.

The UFS interface 1300 may include a line configured to transmit a reference clock signal REF_CLK, a line configured to transmit a hardware reset signal RESET_n for the UFS device 1200, a pair of lines configured to transmit a pair of differential input signals DIN_t and DIN_c, and a pair of lines configured to transmit a pair of differential output signals DOUT_t and DOUT_c.

A frequency of a reference clock signal REF_CLK provided from the UFS host 1100 to the UFS device 1200 may be one of 19.2MHz, 26MHz, 38.4MHz, and 52MHz, without being limited thereto. The UFS host 1100 may change the frequency of the reference clock signal REF_CLK during an operation, for example, during data transmission/receiving operations between the UFS host 1100 and the UFS device 1200. The UFS device 1200 may generate cock signals having various frequencies from the reference clock signal REF_CLK provided from the UFS host 1100, by using a phase-locked loop (PLL). Additionally, or alternatively, the UFS host 1100 may set a data rate between the UFS host 1100 and the UFS device 1200 by using the frequency of the reference clock signal REF_CLK. For example, the data rate may be determined depending on the frequency of the reference clock signal REF_CLK.

The UFS interface 1300 may support a plurality of lanes, each of which may be implemented as a pair of differential lines. For example, the UFS interface 1300 may include at least one receiving lane and at least one transmission lane. In FIG. 17, a pair of lines configured to transmit a pair of differential input signals DIN_T and DIN_C may constitute a receiving lane, and a pair of lines configured to transmit a pair of differential output signals DOUT_T and DOUT_C may constitute a transmission lane. Although one transmission lane and one receiving lane are illustrated in FIG. 17, example embodiments are not limited thereto and the number of transmission lanes and the number of receiving lanes may be changed.

The receiving lane and the transmission lane may transmit data based on a serial communication scheme. Full-duplex communications between the UFS host 1100 and the UFS device 1200 may be enabled due to a structure in which the receiving lane is separated from the transmission lane. For example, while receiving data from the UFS host 1100 through the receiving lane, the UFS device 1200 may transmit data to the UFS host 1100 through the transmission lane. Additionally, or alternatively, control data (e.g., a command) from the UFS host 1100 to the UFS device 1200 and user data to be stored in or read from the NVM storage 1220 of the UFS device 1200 by the UFS host 1100 may be transmitted through the same lane. Accordingly, between the UFS host 1100 and the UFS device 1200, there may be no need to further provide a separate lane for data transmission in addition to a pair of receiving lanes and a pair of transmission lanes.

The UFS device controller 1210 of the UFS device 1200 may control all operations of the UFS device 1200. The UFS device controller 1210 may manage the NVM storage 1220 by using a logical unit (LU) 1211, which may be a logical data storage unit. The number of LUs 1211 may be 8, without being limited thereto. The UFS device controller 1210 may include an FTL and convert a logical data address (e.g., a logical block address (LBA)) received from the UFS host 1100 into a physical data address (e.g., a physical block address (PBA)) by using address mapping information of the FTL. A logical block configured to store user data in the UFS system 1000 may have a size in a predetermined range (or desired range). For example, a minimum size (or a size) of the logical block may be set to 4 Kbyte, but example embodiments are not limited thereto.

In some example embodiments, when a command from the UFS host 1100 is applied through the UIC layer 2250 to the UFS device 1200, the UFS device controller 1210 may perform an operation in response to receiving the command and may transmit a completion response to the UFS host 1100 when the operation is completed.

For example, when the UFS host 1100 intends to store user data in the UFS device 1200, the UFS host 1100 may transmit a data storage command to the UFS device 1200. In some example embodiments, when a response (e.g., a 'ready-to-transfer' response) indicating that the UFS host 1100 is ready to receive user data (e.g., ready-to-transfer) is received from the UFS device 1200, the UFS host 1100 may transmit user data to the UFS device 1200. The UFS device controller 1210 may temporarily store (or may store) the received user data in the device memory 1240 and store the user data, which may be temporarily stored (or may be stored) in the device memory 1240, at a selected position of the NVM storage 1220 based on the address mapping information of the FTL.

In some example embodiments, when the UFS host 1100 intends to read the user data stored in the UFS device 1200, the UFS host 1100 may transmit a data read command to the UFS device 1200. The UFS device controller 1210, which may have received the command, may read the user data from the NVM storage 1220 based on the data read command and temporarily store (or store) the read user data in the device memory 1240. During the read operation, the UFS device controller 1210 may detect and correct an error in the read user data by using an ECC engine (not shown) embedded therein. For example, the ECC engine may generate parity bits for write data to be written to the NVM storage 1220, and the generated parity bits may be stored in the NVM storage 1220 along with the write data. During the reading of data from the NVM storage 1220, the ECC engine may correct an error in read data by using the parity bits read from the NVM storage 1220 along with the read data, and output error-corrected read data.

Additionally, or alternatively, the UFS device controller 1210 may transmit user data, which may be temporarily stored (or may be stored) in the device memory 1240, to the UFS host 1100. Additionally, or alternatively, the UFS device controller 1210 may further include an AES engine (not shown). The AES engine may perform at least of an encryption operation and a decryption operation on data transmitted to the UFS device controller 1210 by using a symmetric-key algorithm.

The UFS host 1100 may sequentially store (or may store) commands, which may be transmitted to the UFS device 1200, in the UFS host register 1111, which may serve as a common queue, and sequentially transmit (or transmit) the commands to the UFS device 1200. For example, even while a previously transmitted command may still being processed by the UFS device 1200, for example, even before receiving a notification that the previously transmitted command has been processed by the UFS device 1200, the UFS host 1100 may transmit a next command, which may be on standby in the CQ, to the UFS device 1200. Thus, the UFS device 1200 may also receive a next command from the UFS host 1100 during the processing of the previously transmitted command. A maximum number (or queue depth) of commands that may be stored in the CQ may be, for example, 32, but example embodiments are not limited thereto. Also, the CQ may be implemented as a circular queue in which a start and an end of a command line stored in a queue are indicated by a head pointer and a tail pointer.

Each of the plurality of storage units 1221 may include a memory cell array (not shown) and a control circuit (not shown) configured to control an operation of the memory cell array. The memory cell array may include a 2D memory cell array or a 3D memory cell array. The memory cell array may include a plurality of memory cells. Although each of the memory cells may be a single-level cell (SLC) configured to store 1-bit information, each of the memory cells may be a memory cell configured to store information of 2 bits or more, such as a multi-level cell (MLC), a triple-level cell (TLC), and a quadruple-level cell (QLC), but example embodiments are not limited thereto. The 3D memory cell array may include a vertical NAND string in which at least one memory cell is vertically oriented and located on another memory cell.

Voltages VCC, VCCQ, and VCCQL may be applied as power supply voltages to the UFS device 1200. The voltage VCC may be a main power supply voltage for the UFS device 1200 and be in a range of approximately 2.4 V to 3.6 V, but example embodiments are not limited thereto. The voltages VCCQ and VCCQL may be a power supply voltage for supplying a low voltage mainly to the UFS device controller 1210 or UIC layer 1250. The voltages VCC and VCCQ may be supplied through the regulator 1260 to respective components of the UFS device 1200. The regulator 1260 may be implemented as a set of unit regulators respectively connected to different ones of the power supply voltages described above. The voltage VCCQL may be supplied directly to respective components of the UFS device 1200 not through regulator 1260.

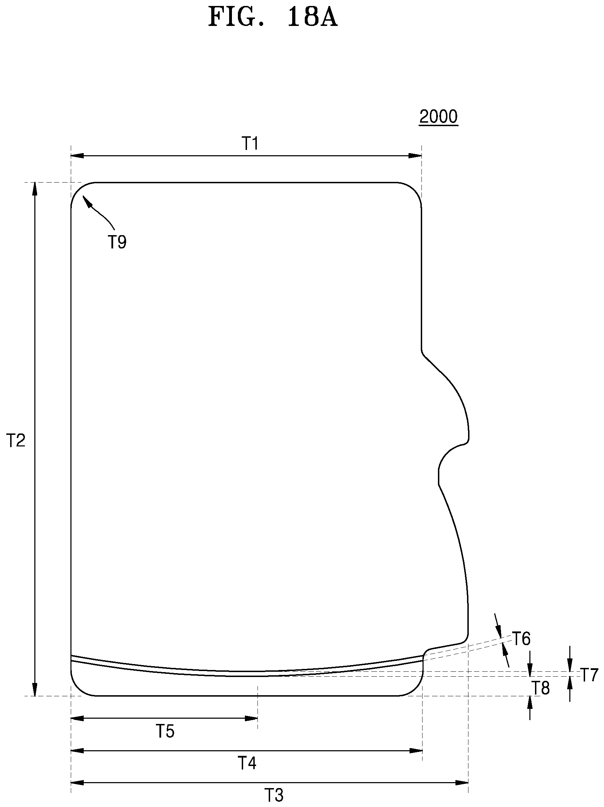

FIGS. 18A to 18C are diagrams of a form factor of a UFS card 2000. When the UFS device 2200 described with reference to FIG. 17 is implemented as the UFS card 2000, an outer appearance of the UFS card 2000 may be as shown in FIGS. 18A to 18C.

FIG. 18A is a top view of the UFS card 2000, according to some example embodiments. Referring to FIG. 18A, it can be seen that the UFS card 2000 follows (or entirely follows) a shark-shaped design, but example embodiments are not limited thereto. In FIG. 18A, the UFS card 2000 may have dimensions shown in Table 1 below as an example, but example embodiments are not limited thereto.

**[Table 1]**

| **Item** | **Dimension (mm)** |
|---|---|
| T1 | 9.70 |
| T2 | 15.00 |
| T3 | 11.00 |
| T4 | 9.70 |
| T5 | 5.15 |
| T6 | 0.25 |
| T7 | 0.60 |
| T8 | 0.75 |
| T9 | R0.80 |

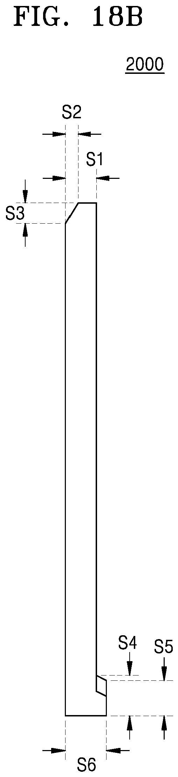

FIG. 18B is a side view of the UFS card 2000, according to some example embodiments. In FIG. 18B, the UFS card 2000 may have dimensions shown in Table 2 below as an example, but example embodiments are not limited thereto.

**[Table 2]**

| **Item** | **Dimension (mm)** |
|---|---|
| S1 | 0.74±0.06 |
| S2 | 0.30 |
| S3 | 0.52 |
| S4 | 1.20 |
| S5 | 1.05 |
| S6 | 1.00 |

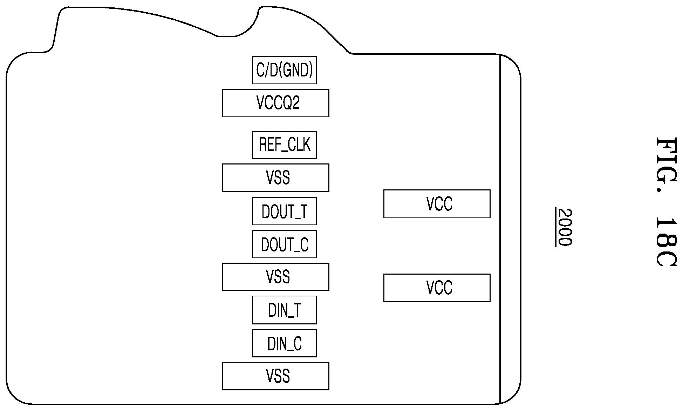

FIG. 18C is a bottom view of the UFS card 2000, according to some example embodiments. Referring to FIG. 18C, a plurality of pins for electrical contact with a UFS slot may be formed on a bottom surface of the UFS card 2000. Functions of each of the pins will be described below. Based on symmetry between a top surface and the bottom surface of the UFS card 2000, some pieces (e.g., T1 to T5 and T9) of information about the dimensions described with reference to FIG. 18A and Table 1 may also be applied to the bottom view of the UFS card 2000, which is shown in FIG. 18C.

A plurality of pins for an electrical connection with a UFS host may be formed on the bottom surface of the UFS card 2000. Referring to FIG. 18C, a total number of pins may be 12. Each of the pins may have a rectangular shape, and signal names corresponding to the pins may be as shown in FIG. 18C, but example embodiments are not limited thereto. Specific information about each of the pins will be understood with reference to Table 3 below and the above description presented with reference to FIG. 17, but example embodiments are not limited thereto.

**[Table 3]**

| **No.** | **Signal Name** | **Description** | **Dimension (mm)** |
|---|---|---|---|
| 1 | Vss | Ground (GND) | 3.00 × 0.72±0.05 |
| 2 | DIN_C | Differential input signals input from a host to the UFS card 2000 (DIN_C is a negative node, and DIN_T is a positive node) | 1.50 × 0.72±0.05 |
| 3 | DIN_T | | |
| 4 | Vss | Ground (GND) | 3.00 × 0.72±0.05 |
| 5 | DOUT_C | Differential output signals output from the UFS card 2000 to the host (DOUT_C is a negative node, and DOUT_T is a positive node) | 1.50 × 0.72±0.05 |
| 6 | DOUT_T | | |
| 7 | Vss | Ground (GND) | 3.00 × 0.72±0.05 |
| 8 | REF_CLK | Reference clock signal provided from the host to the UFS card 2000 | 1.50 × 0.72±0.05 |
| 9 | VCCQ2 | Power supply voltage provided mainly to a PHY interface or a controller and having a lower value than voltage Vcc | 3.00 × 0.72±0.05 |
| 10 | C/D(GND) | Card detection signal | 1.50 × 0.72±0.05 |
| 11 | Vss | Ground (GND) | 3.00 × 0.80±0.05 |
| 12 | Vcc | Main power supply voltage | |

In some example embodiments, the pin corresponding to VCCQ2 may be used for the voltage VCCQL. In some example embodiments, pins for voltages VCCQ and VCCQL may be formed on the bottom surface of the UFS card 2000.

As described above, some example embodiments have been disclosed in the present drawings and specification. Although the example embodiments have been described using a specific term herein, this is used for the purpose of explaining the technical thoughts of inventive concepts. Thus, it will be understood by one of ordinary skill in the art that a variety of modifications and equal examples are possible therefrom. The scope of the invention is defined by the appended claims.

One or more of the elements disclosed above may include or be implemented in one or more processing circuitries such as hardware including logic circuits; a hardware/software combination such as a processor executing software; or a combination thereof. For example, the processing circuitries more specifically may include, but is not limited to, a central processing unit (CPU), an arithmetic logic unit (ALU), a digital signal processor, a microcomputer, a field programmable gate array (FGPA), a System-on-Chip (SoC), a programmable logic unit, a microprocessor, application-specific integrated circuit (ASIC), etc.

While inventive concepts have been particularly shown and described with reference to embodiments thereof, it will be understood that various changes in form and details may be made therein without departing from the scope of the following claims.

## Claims

1. An operating method of a storage device (200), the operating method comprising:
providing mapping information (VL_CNF) to a host (100) when an initialization operation is performed, the mapping information (VL_CNF) including information about a plurality of data transmission rates (LS1, LS2, HS1 - HS6) and voltage levels (VL1 - VL4) of a first voltage (VCCQL);
receiving the first voltage (VCCQL) from the host (100) through a first voltage pin (P7'), the first voltage (VCCQL) having a first voltage level (VL1);
receiving a first change request (DRC_REQ) from the host (100), the first change request (DRC_REQ) being a request to change a data transmission rate from a first data transmission rate (DR1) to a second data transmission rate (DR2); and
receiving the first voltage (VCCQL) from the host (100) through the first voltage pin (P7'), the first voltage (VCCQL) having a second voltage level (VL2) mapped to the second data transmission rate (DR2).

2. The operating method of claim 1, wherein the second data transmission rate (DR2) is slower than the first data transmission rate (DR1), and the second voltage level (VL2) is lower than the first voltage level (VL1).

3. The operating method of claim 1, wherein the second data transmission rate (DR2) is faster than the first data transmission rate (DR1), and the second voltage level (VL2) is higher than the first voltage level (VL1).

4. The operating method of claim 1, 2 or 3, further comprising:
transmitting a response (DRC_CNF) to the first change request (DRC_REQ) to the host (100),
wherein the receiving of the first voltage (VCCQL) having the second voltage level (VL2) through the first voltage pin (P7') is performed after the response (DRC_CNF) to the first change request (DRC_REQ) is transmitted to the host (100).

5. The operating method of any one of claims 1 to 4, wherein the receiving of the first change request (DRC_REQ) to change the data transmission rate from the first data transmission rate (DR1) to the second data transmission rate (DR2) is performed after the receiving of the first voltage (VCCQL) having the second voltage level (VL2) through the first voltage pin (P7').

6. The operating method of any one of claims 1 to 5, further comprising:
receiving a second voltage (VCCQ) through a second voltage pin (P6') when the initialization operation is performed;
generating a regulated voltage by regulating the second voltage (VCCQ);
driving an internal circuit (210) by using the regulated voltage as a driving voltage; and
switching the driving voltage from the regulated voltage to the first voltage (VCCQL) received through the first voltage pin (P7') after the initialization operation is performed.

7. The operating method of claim 6, wherein a voltage level of the second voltage (VCCQ) is higher than the first voltage level (VL1) of the first voltage (VCCQL).

8. The operating method of any one of claims 1 to 7, further comprising:
providing a line-reset signal (LINE-RESET) to the host (100) through a line connected to the host (100) when the initialization operation is performed,
wherein a length of the line-reset signal (LINE-RESET) represents the first voltage level (VL1).

9. The operating method of any one of claims 1 to 8, further comprising:
providing data to the host (100) based on the first data transmission rate (DR1) after the initialization operation is performed,
wherein the mapping information (VL_CNF) about voltage levels (VL1 - VL4) corresponding to the plurality of data transmission rates (LS1, LS2, HS1 - HS6) includes mapping information (VL_CNF) about the first data transmission rate (DR1) and the first voltage level (VL1).

10. A storage device (200) comprising:
a non-volatile memory (230);
an interconnect circuit (210) connected to a host (100) through an at least one pin (P1', P2');
a first pin (P7') configured to receive a first voltage (VCCQL); and
a device controller (220) configured to:
control an operation of the non-volatile memory (230) based on a command received through the input/output pin,
provide mapping information (VL_CNF) about data transmission rates (LS1, LS2, HS1 - HS6) and voltage levels (VL1 - VL4) to the host (100) through the input/output pin, and
drive the interconnect circuit (210) based on a first voltage (VCCQL) having a voltage level mapped to a data transmission rate about the at least one pin.

11. The storage device (200) of claim 10, further comprising:
a second pin (P6') configured to receive a second voltage (VCCQ),
wherein the device controller (220) is configured to drive the interconnect circuit (210) based on a voltage regulated by regulating the second voltage (VCCQ) when an initialization operation is performed, and drive the interconnect circuit (210) by using the first voltage (VCCQL) after the initialization operation is performed.

12. The storage device (200) of claim 10 or 11, wherein the interconnect circuit (210) is configured to receive a data transmission rate change request (DRC_REQ) to change a data transmission rate from a first data transmission rate (DR1) to a second data transmission rate (DR2) when a data transmission rate change operation is performed, and a voltage level of the first voltage (VCCQL) received through the first pin (P7') is changed from a first voltage level (VL1) mapped to the first data transmission rate (DR1) to a second voltage level (VL2) mapped to the second data transmission rate (DR2).

13. The storage device (200) of claim 12, wherein the second data transmission rate (DR2) is faster than the first data transmission rate (DR1), and the second voltage level (VL2) is higher than the first voltage level (VL1).

14. The storage device (200) of claim 12 or 13, wherein the voltage level of the first voltage (VCCQL) is changed to the second voltage level (VL2) before the interconnect circuit (210) receives the data transmission rate change request (DRC_REQ).

15. The storage device (200) of claim 12, 13, or 14, wherein the second data transmission rate (DR2) is slower than the first data transmission rate (DR1), and the second voltage level (VL2) is lower than the first voltage level (VL1).

## Patentansprüche

1. Betriebsverfahren für eine Speichervorrichtung (200), wobei das Betriebsverfahren umfasst:
Bereitstellen von Zuordnungsinformationen (VL_CNF) an einen Host (100), wenn eine Initialisierungsoperation durchgeführt wird, wobei die Zuordnungsinformationen (VL_CNF) Informationen über eine Vielzahl von Datenübertragungsraten (LS1, LS2, HS1 - HS6) und Spannungspegeln (VL1 - VL4) einer ersten Spannung (VCCQL) beinhalten;
Empfangen der ersten Spannung (VCCQL) vom Host (100) über einen ersten Spannungspin (P7'), wobei die erste Spannung (VCCQL) einen ersten Spannungspegel (VL1) aufweist;
Empfangen einer ersten Änderungsanforderung (DRC_REQ) vom Host (100), wobei die erste Änderungsanforderung (DRC_REQ) eine Anforderung ist, eine Datenübertragungsrate von einer ersten Datenübertragungsrate (DR1) auf eine zweite Datenübertragungsrate (DR2) zu ändern; und
Empfangen der ersten Spannung (VCCQL) vom Host (100) über den ersten Spannungspin (P7'), wobei die erste Spannung (VCCQL) einen zweiten Spannungspegel (VL2) aufweist, der der zweiten Datenübertragungsrate (DR2) zugeordnet ist.

2. Betriebsverfahren nach Anspruch 1, wobei die zweite Datenübertragungsrate (DR2) langsamer ist als die erste Datenübertragungsrate (DR1), und der zweite Spannungspegel (VL2) niedriger ist als der erste Spannungspegel (VL1).

3. Betriebsverfahren nach Anspruch 1, wobei die zweite Datenübertragungsrate (DR2) schneller ist als die erste Datenübertragungsrate (DR1), und der zweite Spannungspegel (VL2) höher ist als der erste Spannungspegel (VL1).

4. Betriebsverfahren nach Anspruch 1, 2 oder 3, ferner umfassend:
Übertragen einer Antwort (DRC_CNF) auf die erste Änderungsanforderung (DRC_REQ) an den Host (100),
wobei das Empfangen der ersten Spannung (VCCQL), die den zweiten Spannungspegel (VL2) aufweist, über den ersten Spannungspin (P7') durchgeführt wird, nachdem die Antwort (DRC_CNF) auf die erste Änderungsanforderung (DRC_REQ) an den Host (100) übertragen wurde.

5. Betriebsverfahren nach einem der Ansprüche 1 bis 4, wobei das Empfangen der ersten Änderungsanforderung (DRC_REQ), die Datenübertragungsrate von der ersten Datenübertragungsrate (DR1) zur zweiten Datenübertragungsrate (DR2) zu ändern, nach dem Empfangen der ersten Spannung (VCCQL), die den zweiten Spannungspegel (VL2) aufweist, über den ersten Spannungspin (P7') durchgeführt wird.

6. Betriebsverfahren nach einem der Ansprüche 1 bis 5, ferner umfassend:
Empfangen einer zweiten Spannung (VCCQ) über einen zweiten Spannungspin (P6'), wenn die Initialisierungsoperation durchgeführt wird;
Erzeugen einer geregelten Spannung durch Regeln der zweiten Spannung (VCCQ);
Ansteuern eines internen Schaltkreises (210) unter Verwendung der geregelten Spannung als eine Ansteuerspannung; und
Umschalten der Ansteuerspannung von der geregelten Spannung auf die erste Spannung (VCCQL), die über den ersten Spannungspin (P7') empfangen wird, nachdem die Initialisierungsoperation durchgeführt wurde.

7. Verfahren nach Anspruch 6, wobei ein Spannungspegel der zweiten Spannung (VCCQ) höher ist als der erste Spannungspegel (VL1) der ersten Spannung (VCCQL).

8. Betriebsverfahren nach einem der Ansprüche 1 bis 7, ferner umfassend:
Bereitstellen eines Leitungsrücksetzsignals (LINE-RESET) an den Host (100) über eine mit dem Host (100) verbundene Leitung, wenn die Initialisierungsoperation durchgeführt wird,
wobei eine Länge des Leitungsrücksetzsignals (LINE-RESET) den ersten Spannungspegel (VL1) darstellt.

9. Verfahren nach einem der Ansprüche 1 bis 8, ferner umfassend:
Bereitstellen von Daten an den Host (100) basierend auf der ersten Datenübertragungsrate (DR1), nachdem die Initialisierungsoperation durchgeführt wurde,
wobei die Zuordnungsinformationen (VL_CNF) über Spannungspegel (VL1 - VL4), die der Vielzahl von Datenübertragungsraten (LS1, LS2, HS1 - HS6) entsprechen, Zuordnungsinformationen (VL_CNF) über die erste Datenübertragungsrate (DR1) und den ersten Spannungspegel (VL1) beinhalten.

10. Speichervorrichtung (200), umfassend:
einen nichtflüchtigen Speicher (230);
einen Zwischenverbindungsschaltkreis (210), der über mindestens einen Pin (P1', P2') mit einem Host (100) verbunden ist;
einen ersten Pin (P7'), der so konfiguriert ist, dass er eine erste Spannung (VCCQL) empfängt; und
eine Vorrichtungssteuereinheit (220), die konfiguriert ist für:
Steuern einer Operation des nichtflüchtigen Speichers (230) basierend auf einem Befehl, der über den Eingabe/Ausgabe-Pin empfangen wird,
Bereitstellen von Zuordnungsinformationen (VL_CNF) über Datenübertragungsraten (LS1, LS2, HS1 - HS6) und Spannungspegel (VL1 - VL4) an den Host (100) über den Eingabe/Ausgabe-Pin, und
Ansteuern des Zwischenverbindungsschaltkreises (210) basierend auf einer ersten Spannung (VCCQL), die einen Spannungspegel aufweist, der einer Datenübertragungsrate rund um den mindestens einen Pin zugeordnet ist.

11. Speichervorrichtung (200) nach Anspruch 10, ferner umfassend:
einen zweiten Pin (P6'), der so konfiguriert ist, dass er eine zweite Spannung (VCCQ) empfängt,
wobei die Vorrichtungssteuereinheit (220) so konfiguriert ist, dass sie den Zwischenverbindungsschaltkreis (210) basierend auf einer Spannung ansteuert, die durch Regulieren der zweiten Spannung (VCCQ) geregelt wird, wenn eine Initialisierungsoperation durchgeführt wird, und den Zwischenverbindungsschaltkreis (210) unter Verwendung der ersten Spannung (VCCQL) ansteuert, nachdem die Initialisierungsoperation durchgeführt wurde.

12. Speichervorrichtung (200) nach Anspruch 10 oder 11, wobei der Zwischenverbindungsschaltkreis (210) so konfiguriert ist, dass sie eine Datenübertragungsratenänderungsanforderung (DRC_REQ) empfängt, eine Datenübertragungsrate von einer ersten Datenübertragungsrate (DR1) auf eine zweite Datenübertragungsrate (DR2) zu ändern, wenn eine Datenübertragungsratenänderungsoperation durchgeführt wird, und ein Spannungspegel der ersten Spannung (VCCQL), die über den ersten Pin (P7') empfangen wird, von einem ersten Spannungspegel (VL1), der der ersten Datenübertragungsrate (DR1) zugeordnet ist, auf einen zweiten Spannungspegel (VL2), der der zweiten Datenübertragungsrate (DR2) zugeordnet ist, geändert wird.

13. Speichervorrichtung (200) nach Anspruch 12, wobei die zweite Datenübertragungsrate (DR2) schneller ist als die erste Datenübertragungsrate (DR1), und der zweite Spannungspegel (VL2) höher ist als der erste Spannungspegel (VL1).

14. Speichervorrichtung (200) nach Anspruch 12 oder 13, wobei der Spannungspegel der ersten Spannung (VCCQL) auf den zweiten Spannungspegel (VL2) geändert wird, bevor der Zwischenverbindungsschaltkreis (210) die Datenübertragungsratenänderungsanforderung (DRC_REQ) empfängt.

15. Speichervorrichtung (200) nach Anspruch 12, 13 oder 14, wobei die zweite Datenübertragungsrate (DR2) langsamer ist als die erste Datenübertragungsrate (DR1), und der zweite Spannungspegel (VL2) niedriger ist als der erste Spannungspegel (VL1).

## Revendications

1. Procédé de fonctionnement d'un dispositif de stockage (200), le procédé de fonctionnement comprenant :
la fourniture d'informations de mappage (VL_CNF) à un hôte (100) lorsque d'une opération d'initialisation est réalisée, les informations de mappage (VL_CNF) incluant des informations relatives à une pluralité de débits de transmission de données (LS1, LS2, HS1 - HS6) et de niveaux de tension (VL1 - VL4) d'une première tension (VCCQL) ;
la réception de la première tension (VCCQL) en provenance de l'hôte (100) par l'intermédiaire d'une première broche de tension (P7'), la première tension (VCCQL) présentant un premier niveau de tension (VL1) ;
la réception d'une première demande de changement (DRC_REQ) en provenance de l'hôte (100), la première demande de changement (DRC_REQ) étant une demande de changement d'un débit de transmission de données d'un premier débit de transmission de données (DR1) à un second débit de transmission de données (DR2) ; et
la réception de la première tension (VCCQL) en provenance de l'hôte (100) par l'intermédiaire de la première broche de tension (P7'), la première tension (VCCQL) présentant un second niveau de tension (VL2) mappé sur le second débit de transmission de données (DR2).

2. Procédé de fonctionnement selon la revendication 1, dans lequel le second débit de transmission de données (DR2) est plus lent que le premier débit de transmission de données (DR1), et le second niveau de tension (VL2) est inférieur au premier niveau de tension (VL1).

3. Procédé de fonctionnement selon la revendication 1, dans lequel le second débit de transmission de données (DR2) est plus rapide que le premier débit de transmission de données (DR1), et le second niveau de tension (VL2) est supérieur au premier niveau de tension (VL1).

4. Procédé de fonctionnement selon la revendication 1, 2 ou 3, comprenant en outre :
la transmission d'une réponse (DRC_CNF) à la première demande de changement (DRC_REQ) à l'hôte (100),
dans lequel la réception de la première tension (VCCQL) présentant le second niveau de tension (VL2) par l'intermédiaire de la première broche de tension (P7') est réalisée après que la réponse (DRC_CNF) à la première demande de changement (DRC_REQ) a été transmise à l'hôte (100).

5. Procédé de fonctionnement selon l'une quelconque des revendications 1 à 4, dans lequel la réception de la première demande de changement (DRC_REQ) pour changer le débit de transmission de données du premier débit de transmission de données (DR1) au second débit de transmission de données (DR2) est réalisé après la réception de la première tension (VCCQL) présentant le second niveau de tension (VL2) par l'intermédiaire de la première broche de tension (P7').

6. Procédé de fonctionnement selon l'une quelconque des revendications 1 à 5, comprenant en outre :
la réception d'une seconde tension (VCCQ) par l'intermédiaire d'une seconde broche de tension (P6') lorsque l'opération d'initialisation est réalisée ;
la génération d'une tension régulée en régulant la seconde tension (VCCQ) ;
la commande d'un circuit interne (210) en utilisant la tension régulée en tant que tension de commande ; et
la commutation de la tension de commande de la tension régulée à la première tension (VCCQL) reçue par l'intermédiaire de la première broche de tension (P7') après que l'opération d'initialisation a été réalisée.

7. Procédé de fonctionnement selon la revendication 6, dans lequel un niveau de tension de la seconde tension (VCCQ) est supérieur au premier niveau de tension (VL1) de la première tension (VCCQL).

8. Procédé de fonctionnement selon l'une quelconque des revendications 1 à 7, comprenant en outre :
la fourniture d'un signal de réinitialisation de ligne (LINE-RESET) à l'hôte (100) par l'intermédiaire d'une ligne connectée à l'hôte (100) lorsque l'opération d'initialisation est réalisée,
dans lequel une longueur du signal de réinitialisation de ligne (LINE-RESET) représente le premier niveau de tension (VL1).

9. Procédé de fonctionnement selon l'une quelconque des revendications 1 à 8, comprenant en outre :
la fourniture de données à l'hôte (100) sur la base du premier débit de transmission de données (DR1) après que l'opération d'initialisation a été réalisée,
dans lequel les informations de mappage (VL_CNF) relative à des niveaux de tension (VL1 - VL4) correspondant à la pluralité de débits de transmission de données (LS1, LS2, HS1 - HS6) incluent des informations de mappage (VL_CNF) relative au premier débit de transmission de données (DR1) et au premier niveau de tension (VL1).

10. Dispositif de stockage (200) comprenant :
une mémoire non volatile (230) ;
un circuit d'interconnexion (210) connecté à un hôte (100) par l'intermédiaire d'au moins une broche (P1', P2') ;
une première broche (P7') configurée pour recevoir une première tension (VCCQL) ; et
un dispositif de commande de dispositif (220) configuré pour :
commander un fonctionnement de la mémoire non volatile (230) sur la base d'une commande reçue par l'intermédiaire de la broche d'entrée/de sortie,
fournir des informations de mappage (VL_CNF) relative à des débits de transmission de données (LS1, LS2, HS1 - HS6) et des niveaux de tension (VL1 - VL4) à l'hôte (100) par l'intermédiaire de la broche d'entrée/de sortie, et
la commande du circuit d'interconnexion (210) sur la base d'une première tension (VCCQL) présentant un niveau de tension mappé sur un débit de transmission de données sur l'au moins une broche.

11. Dispositif de stockage (200) selon la revendication 10, comprenant en outre :
une seconde broche (P6') configurée pour recevoir une seconde tension (VCCQ),
dans lequel le dispositif de commande de dispositif (220) est configuré pour commander le circuit d'interconnexion (210) sur la base d'une tension régulée en régulant la seconde tension (VCCQ) lorsqu'une opération d'initialisation est réalisée et commander le circuit d'interconnexion (210) en utilisant la première tension (VCCQL) après que l'opération d'initialisation a été réalisée.

12. Dispositif de stockage (200) selon la revendication 10 ou 11, dans lequel le circuit d'interconnexion (210) est configuré pour recevoir une demande de changement de débit de transmission de données (DRC_REQ) pour changer un débit de transmission de données d'un premier débit de transmission de données (DR1) à un second débit de transmission de données (DR2) lorsqu'une opération de changement de débit de transmission de données est réalisée et qu'un niveau de tension de la première tension (VCCQL) reçue par l'intermédiaire de la première broche (P7') est changé d'un premier niveau de tension (VL1) mappé sur le premier débit de transmission de données (DR1) à un second niveau de tension (VL2) mappé sur le second débit de transmission de données (DR2).

13. Dispositif de stockage (200) selon la revendication 12, dans lequel le second débit de transmission de données (DR2) est plus rapide que le premier débit de transmission de données (DR1), et le second niveau de tension (VL2) est supérieur au premier niveau de tension (VL1).

14. Dispositif de stockage (200) selon la revendication 12 ou 13, dans lequel le niveau de tension de la première tension (VCCQL) est changé au second niveau de tension (VL2) avant que le circuit d'interconnexion (210) reçoive la demande de changement de débit de transmission de données (DRC_REQ).

15. Dispositif de stockage (200) selon la revendication 12, 13 ou 14, dans lequel le second débit de transmission de données (DR2) est plus lent que le premier débit de transmission de données (DR1), et le second niveau de tension (VL2) est inférieur au premier niveau de tension (VL1).
